# EUROPEAN PATENT APPLICATION

(11) **EP 4 307 864 A1**
(43) Date of publication of application: **17.01.2024**
(21) Application number: 23184878.9
(22) Date of filing: 11.07.2023
(51) Int. Cl.: H10K 59/121, H10K 59/126, H10K 59/35, H10K 59/38, H10K 59/80

(54) **ELECTRONIC DEVICE**

(30) Priority: 14.07.2022 KR 20220086898
(71) Applicant: Samsung Display Co., Ltd., Yongin-si, Gyeonggi-do 17113 (KR)
(72) Inventor: CHOI, Kyung Hyun, 17113 Yongin-si (KR); WANG, Seong Min, 17113 Yongin-si (KR)
(74) Representative: Walaski, Jan Filip

(57) **Abstract**

An electronic device includes a display panel including a first area including a plurality of transmission areas and an element area, a second area spaced apart from the first area, and a boundary area defined between the first area and the second area. The display panel includes a division layer in which a plurality of first division is openings defined in the first area and a plurality of second division openings is defined in the second area, a plurality of first colour filters including a first-first colour filter, a first-second colour filter, and a first-third colour filter, which are arranged in each of the first division openings, and a plurality of second colour filters corresponding to the second division openings in a one-to-one correspondence.

## Description

This application claims priority to Korean Patent Application No. 10-2022-0086898, filed on July 14, 2022.

### BACKGROUND

### 1. Field

The disclosure relates to an electronic device with improved reflective luminosity.

### 2. Description of the Related Art

An electronic device includes various electronic parts such as a display panel, an electronic module, and the like. The electronic module includes a camera, an infrared sensor, or a proximity sensor. The electronic module is disposed under the display panel. A portion of the display panel has a transmittance higher than that of another portion of the display panel. The electronic module receives external inputs or provides outputs through the portion of the display panel with relatively high transmittance.

### SUMMARY

The disclosure provides an electronic device capable of reducing a difference in reflective luminosity between areas with colour filters having different shapes from each other.

An embodiment of the inventive concept provides an electronic device including a display panel including a first area including a plurality of transmission areas and an element area, a second area spaced apart from the first area, and a boundary area defined between the first area and the second area. The display panel includes a division layer in which a plurality of first division openings is defined in the first area and a plurality of second division openings is defined in the second area, a plurality of first colour filters including a first-first colour filter, a first-second colour filter, and a first-third colour filter, which are arranged in each of the plurality of first division openings, and a plurality of second colour filters corresponding to the plurality of second division openings in a one-to-one correspondence.

In an embodiment, a plurality of transmission openings defined in the first area may be defined in the division layer, and each of the plurality of first division openings may be defined between four transmission openings among the plurality of transmission openings.

In an embodiment, the first-second colour filter may include an overlapping portion overlapping one first division opening among the plurality of first division openings and an extension portion extending from the overlapping portion.

In an embodiment, the extension portion may include a portion of the first-second colour filter, which protrudes outward in a first direction than the first-first colour filter, and a portion of the first-second colour filter, which protrudes outward in a second direction crossing the first direction than the first-third colour filter.

In an embodiment, the extension portion may extend from the overlapping portion to an area between two transmission areas adjacent to each other among the plurality of transmission areas.

In an embodiment, the extension portion may surround the first-first colour filter and the first-third colour filter.

In an embodiment, a portion of the division layer may have a shape corresponding to a shape of the extension portion in the first area.

In an embodiment, the display panel may further include an additional colour filter having a colour identical to a colour of the first-second colour filter, and the additional colour filter may be disposed in an area between two transmission areas adjacent to each other among the plurality of transmission areas.

In an embodiment, the extension portion may extend to the first-third colour filter overlapping another first division opening among the plurality of first division openings, and the additional colour filter may face the first-first colour filter overlapping the one first division opening and extend to the first-third colour filter overlapping still another first division opening among the plurality of first division openings.

In an embodiment, the first-first colour filter may include a first overlapping portion overlapping one first division opening among the plurality of first division openings and a first extension portion extending from the first overlapping portion, the first-second colour filter may include a second overlapping portion overlapping the one first division opening and a second extension portion extending from the second overlapping portion, and the first-third colour filter may include a third overlapping portion overlapping the one first division opening and a third extension portion extending from the third overlapping portion.

In an embodiment, the first extension portion may extend to an area between two transmission areas adjacent to each other among the plurality of transmission areas, the second extension portion may extend to an area between two transmission areas adjacent to each other among the plurality of transmission areas, and the third extension portion may extend to an area between two transmission areas adjacent to each other among the plurality of transmission areas.

In an embodiment, a first additional division opening defined in an area overlapping the first extension portion, a second additional division opening defined in an area overlapping the second extension portion, and a third additional division opening defined in an area overlapping the third extension portion may be defined in the division layer.

In an embodiment, a plurality of third division openings and a plurality of fourth division openings, which are defined in the boundary area, may be defined in the division layer, and each of the plurality of third division openings may have a shape identical to a shape of each of the plurality of first division openings, and each of the plurality of fourth division openings may have a shape identical to a shape of each of the plurality of second division openings.

In an embodiment, the display panel may further include a plurality of third colour filters including a third-first colour filter, a third-second colour filter, and a third-third colour filter, which are arranged in each of the plurality of third division openings, and a plurality of fourth colour filters corresponding to the plurality of fourth division openings in a one-to-one correspondence.

In an embodiment, the display panel may further include a plurality of dummy colour filters arranged in the boundary area, the plurality of dummy colour filters may include a plurality of first dummy colour filters, a plurality of second dummy colour filters, and a plurality of third dummy colour filters, and the plurality of first dummy colour filters, the plurality of second dummy colour filters, and the plurality of third dummy colour filters may have different colours from each other.

In an embodiment, the first area may be divided into quadrants by a first axis and a second axis crossing the first axis at a center of the first area, the boundary area may include a first boundary area adjacent to a first quadrant of the first area, a second boundary area adjacent to a second quadrant of the first area, a third boundary area adjacent to a third quadrant of the first area, and a fourth boundary area adjacent to a fourth quadrant of the first area, and the plurality of dummy colour filters may be arranged according to arrangement rules corresponding to the first, second, third, and fourth boundary areas, respectively.

In an embodiment, the plurality of second dummy colour filters may be arranged in the first boundary area and the second boundary area, the plurality of first dummy colour filters, the plurality of second dummy colour filters, and the plurality of third dummy colour filters may be arranged in the third boundary area, and the plurality of first dummy colour filters and the plurality of second dummy colour filters may be arranged in the fourth boundary area.

In an embodiment, a plurality of dummy division openings defined in the boundary area and overlapping the plurality of dummy colour filters may be defined in the division layer.

In an embodiment, the display panel may further include a pixel definition layer through which a plurality of pixel definition openings defining a plurality of light-emitting areas is defined, the plurality of second colour filters may include a second-first colour filter, a second-second colour filter, and a second-third colour filter, the plurality of pixel definition openings may include a first pixel definition opening overlapping the second-first colour filter, a second pixel definition opening overlapping the second-second colour filter, and a third pixel definition opening overlapping the second-third colour filter, the second-first colour filter may have a size greater than a size of the second-third colour filter, and the first pixel definition opening may have a size smaller than a size of the third pixel definition opening.

In an embodiment, the display panel may further include a first spacer disposed on the pixel definition layer and disposed in the second area and the boundary area, a plurality of first protruded spacers disposed on the first spacer and disposed in the second area, a second spacer disposed on the pixel definition layer and disposed in the first area, and a second protruded spacer disposed on the second spacer, wherein the plurality of first protruded spacers may not overlap the boundary area.

An embodiment of the inventive concept provides an electronic device including a display panel including a first area including a plurality of transmission areas and an element area, a second area spaced apart from the first area, and a boundary area defined between the first area and the second area. The display panel includes a plurality of first colour filters arranged in the first area, a plurality of second colour filters arranged in the second area, a plurality of third colour filters arranged in the boundary area, a plurality of fourth colour filters arranged in the boundary area and having a shape different from a shape of the plurality of third colour filters, and a plurality of dummy colour filters arranged in the boundary area and disposed between the plurality of third colour filters and the plurality of fourth colour filters.

In an embodiment, the first area may be divided into quadrants by a first axis and a second axis crossing the first axis at a center of the first area, the boundary area may include a first boundary area adjacent to a first quadrant of the first area, a second boundary area adjacent to a second quadrant of the first area, a third boundary area adjacent to a third quadrant of the first area, and a fourth boundary area adjacent to a fourth quadrant of the first area, the plurality of dummy colour filters may include a plurality of first dummy colour filters, a plurality of second dummy colour filters, and a plurality of third dummy colour filters, the plurality of first dummy colour filters, the plurality of second dummy colour filters, and the plurality of third dummy colour filters may have different colours from each other, the plurality of second dummy colour filters may be arranged in the first boundary area and the second boundary area, the plurality of first dummy colour filters, the plurality of second dummy colour filters, and the plurality of third dummy colour filters may be arranged in the third boundary area, and the plurality of first dummy colour filters and the plurality of second dummy colour filters may be arranged in the fourth boundary area.

In an embodiment, the display panel may further include a division layer in which a plurality of first division openings is defined in the first area, a plurality of second division openings is defined in the second area, and a plurality of third division openings and a plurality of fourth division openings are defined in the boundary area, the plurality of first colour filters includes a first-first colour filter, a first-second colour filter, and a first-third colour filter, which overlap one first division opening among the plurality of first division openings, and the first-second colour filter may include an overlapping portion overlapping the one first division opening among the plurality of first division openings and an extension portion extending from the overlapping portion.

In an embodiment, the extension portion may include a portion of the first-second colour filter, which protrudes outward in a first direction than the first-first colour filter, and another portion of the first-second colour filter, which protrudes outward in a second direction crossing the first direction than the first-third colour filter.

In an embodiment, a plurality of transmission openings defined in the first area may be defined in the division layer, and each of the plurality of first division openings may be defined between four transmission openings among the plurality of transmission openings.

In an embodiment, the extension portion may extend from the overlapping portion to an area between two transmission areas adjacent to each other among the plurality of transmission areas.

In an embodiment, the extension portion may surround the first-first colour filter and the first-third colour filter, and a portion of the division layer may have a shape corresponding to a shape of the extension portion in the first area.

In an embodiment, the display panel may further include an additional colour filter having a colour identical to a colour of the first-second colour filter, and the additional colour filter may be disposed in an area between two transmission areas adjacent to each other among the plurality of transmission areas.

In an embodiment, the first-first colour filter may include a first overlapping portion overlapping the one first division opening among the plurality of first division openings and a first extension portion extending from the first overlapping portion, and the first-third colour filter may include a third overlapping portion overlapping the one first division opening and a third extension portion extending from the third overlapping portion.

In an embodiment, a first additional division opening defined in an area overlapping the first extension portion, a second additional division opening defined in an area overlapping the extension portion, and a third additional division opening defined in an area overlapping the third extension portion are defined in the division layer.

An embodiment of the inventive concept provides an electronic device including a display panel including a first area including a transmission area and an element area, a second area spaced apart from the first area, and a boundary area defined between the first area and the second area. The display panel includes a pixel definition layer through which a plurality of pixel definition openings defining a plurality of light-emitting areas is defined, a plurality of first colour filters arranged in the first area, a plurality of second colour filters arranged in the second area, and a plurality of third colour filters arranged in the boundary area. The plurality of second colour filters includes a second-first colour filter, a second-second colour filter, and a second-third colour filter, the plurality of pixel definition openings includes a first pixel definition opening overlapping the second-first colour filter, a second pixel definition opening overlapping the second-second colour filter, and a third pixel definition opening overlapping the second-third colour filter, the second-first colour filter has a size greater than a size of the second-third colour filter, and the first pixel definition opening has a size smaller than a size of the third pixel definition opening.

According to the above, the display panel includes the first colour filters disposed in the first area and the second colour filters disposed in the second area. The size of each of the second colour filters is determined by taking into account the colour of reflected light of the electronic device. Accordingly, the size relationship of the light-emitting areas in the second area is not in proportion to (or is not coincident with) the size relationship of the second colour filters corresponding to the light-emitting areas.

According to the above, the size of each of the first colour filters is adjusted, and thus, the colour of reflected light in the first area becomes substantially similar to that in the second area even though the colour filters included in the first area and the second area have different shapes from each other. Thus, when the display panel is in an off-state, a boundary between the first area and the second area is less likely to be visible.

According to the above, the display panel further includes the dummy colour filters disposed in the boundary area between the first area and the second area. The arrangement relationship (or the arrangement rule) of the dummy colour filters is the same as that of the second colour filters. Accordingly, the colour of reflected light in the boundary area becomes substantially close to the colour of reflected light in the second area.

### BRIEF DESCRIPTION OF THE DRAWINGS

The above and other advantages of the disclosure will become readily apparent by reference to the following detailed description when considered in conjunction with the accompanying drawings, in which:
FIGS. 1A and 1B are perspective views showing an embodiment of an electronic device according to the disclosure;
FIG. 2A is an exploded perspective view showing an embodiment of an electronic device according to the disclosure;
FIG. 2B is a block diagram showing an embodiment of an electronic device according to the disclosure;
FIG. 3 is a cross-sectional view of an embodiment of a display device according to the disclosure;
FIG. 4 is a plan view of an embodiment of a display panel according to the disclosure;
FIG. 5 is an equivalent circuit diagram of an embodiment of a pixel according to the disclosure;
FIG. 6 is an enlarged plan view of an embodiment of a portion of a display panel according to the disclosure;
FIG. 7A is a cross-sectional view of an embodiment of a first area of a display panel according to the disclosure;
FIG. 7B is a cross-sectional view of an embodiment of a second area of a display panel according to the disclosure;
FIG. 8A is a plan view of an embodiment of a portion of a first lower light-blocking layer according to the disclosure;
FIG. 8B is a plan view of an embodiment of a portion of a second lower light-blocking layer according to the disclosure;
FIG. 9A is an enlarged plan view of an embodiment of a portion of a display panel according to the disclosure;
FIG. 9B is an enlarged plan view of an embodiment of a portion of a display panel according to the disclosure;
FIG. 10A is a plan view of an embodiment of pixel circuits arranged in a first area according to the disclosure;
FIG. 10B is a plan view of an embodiment of pixel circuits arranged in a second area according to the disclosure;
FIG. 11A is an enlarged plan view of an embodiment of a portion of a display panel according to the disclosure;
FIG. 11B is a plan view of an embodiment of some components of a display panel according to the disclosure;
FIG. 12 is an enlarged plan view of an embodiment of a portion of a display panel according to the disclosure;
FIG. 13 is an enlarged plan view of an embodiment of a portion of a display panel according to the disclosure;
FIGS. 14A, 14B, and 14C are enlarged plan views of embodiments of a portion of a display panel according to the disclosure;
FIG. 15 is an enlarged plan view of an embodiment of a portion of a display panel according to the disclosure;
FIGS. 16A and 16B are enlarged plan views of embodiments of a portion of a display panel according to the disclosure;
FIG. 17 is an enlarged plan view of an embodiment of a portion of a display panel according to the disclosure;
FIG. 18 is an enlarged plan view of an embodiment of a portion of a display panel according to the disclosure;
FIG. 19 is an enlarged plan view of an embodiment of a portion of a display panel according to the disclosure;
FIG. 20 is a plan view of an embodiment of a portion of a display panel according to the disclosure;
FIG. 21A is a plan view of an embodiment of a portion of a display panel according to the disclosure;
FIG. 21B is a plan view of an embodiment of a portion of a display panel according to the disclosure;
FIG. 21C is a plan view of an embodiment of a portion of a display panel according to the disclosure; and
FIG. 21D is a plan view of an embodiment of a portion of a display panel according to the disclosure.

### DETAILED DESCRIPTION

In the disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the drawing figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described with reference to accompanying drawings.

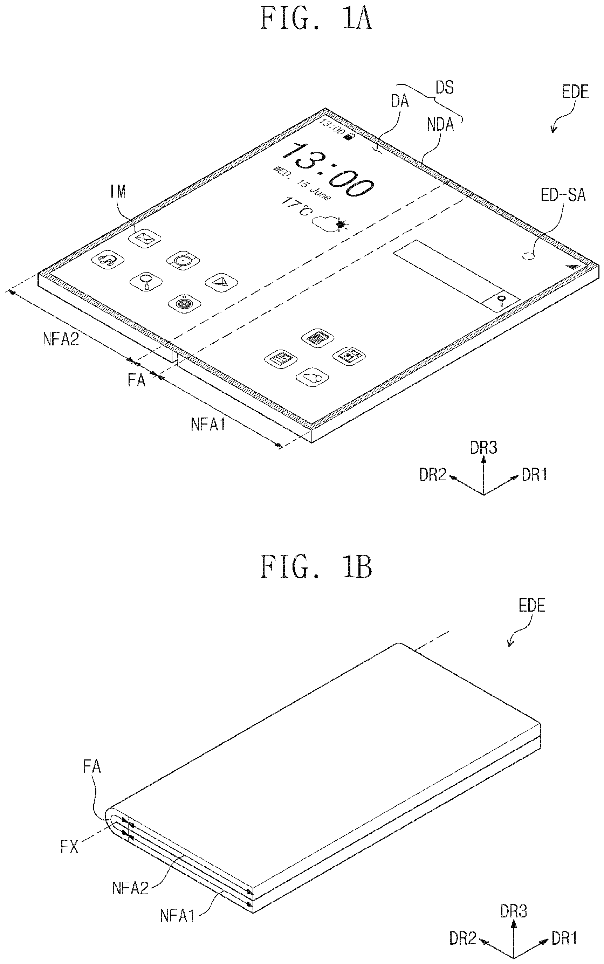

FIGS. 1A and 1B are perspective views showing an embodiment of an electronic device EDE according to the disclosure. FIG. 1A shows an unfolded state of the electronic device EDE, and FIG. 1B shows a folded state of the electronic device EDE.

Referring to FIGS. 1A and 1B, the electronic device EDE may include a display surface DS defined by a first direction DR1 and a second direction DR2 crossing the first direction DR1. The electronic device EDE may provide an image IM to a user through the display surface DS.

The display surface DS may include a display area DA and a non-display area NDA around the display area DA. The image IM may be displayed through the display area DA and may not be displayed through the non-display area NDA. The non-display area NDA may surround the display area DA, however, it should not be limited thereto or thereby, and the shape of the display area DA and the shape of the non-display area NDA may be changed. An "area" is alternatively referred to as a "region".

Hereinafter, a direction substantially perpendicular to a plane defined by the first direction DR1 and the second direction DR2 may be also referred to as a third direction DR3. In the disclosure, the expression "in a plan view" may mean a state of being viewed in the third direction DR3.

A sensing area ED-SA may be defined in the display area DA of the electronic device EDE. FIG. 1A shows one sensing area ED-SA as an illustrative embodiment, however, the number of the sensing areas ED-SA should not be limited thereto or thereby. The sensing area ED-SA may be a portion of the display area DA. Accordingly, the electronic device EDE may display the image IM through the sensing area ED-SA.

The electronic device EDE may include an electronic module disposed in an area overlapping the sensing area ED-SA. The electronic module may receive an external input provided from the outside through the sensing area ED-SA or may output a signal through the sensing area ED-SA. In an embodiment, the electronic module may be a camera module, a sensor that measures a distance, such as a proximity sensor, a sensor that recognizes at least a part of a user's body, e.g., a fingerprint, an iris, or a face, or a substantially small lamp that outputs a light, however, it should not be particularly limited. Hereinafter, the camera module will be described as the electronic module overlapping the sensing area ED-SA.

The electronic device EDE may include a folding area FA and a plurality of non-folding areas NFA1 and NFA2. The non-folding areas NFA1 and NFA2 may include a first non-folding area NFA1 and a second non-folding area NFA2. The folding area FA may be disposed between the first non-folding area NFA1 and the second non-folding area NFA2. The folding area FA may be also referred to as a foldable area, and the first and second non-folding areas NFA1 and NFA2 may be also referred to as first and second non-foldable areas, respectively.

As shown in FIG. 1B, the folding area FA may be folded with respect to a folding axis FX substantially parallel to the first direction DR1. The folding area FA may have a predetermined curvature and a radius of curvature when the electronic device EDE is in the folded state. The electronic device EDE may be inwardly folded (inner-folding) such that the first non-folding area NFA1 may face the second non-folding area NFA2 and the display surface DS may not be exposed to the outside.

In an embodiment, the electronic device EDE may be outwardly folded (outer-folding) such that the display surface DS may be exposed to the outside. In an embodiment, the electronic device EDE may perform the inner-folding operation and an unfolding operation or perform the outer-folding operation and the unfolding operation. In an embodiment, the electronic device EDE may perform any one of the unfolding operation, the inner-folding operation, and the outer-folding operation. In an embodiment, a plurality of folding axes may be defined in the electronic device EDE, and the electronic device EDE may be inwardly or outwardly folded with respect to each folding axis.

FIGS. 1A and 1B show the foldable electronic device EDE as an illustrative embodiment, however, the disclosure should not be limited to the foldable electronic device EDE. In an embodiment, the disclosure may be applied to a rigid electronic device, e.g., an electronic device that does not include the folding area FA.

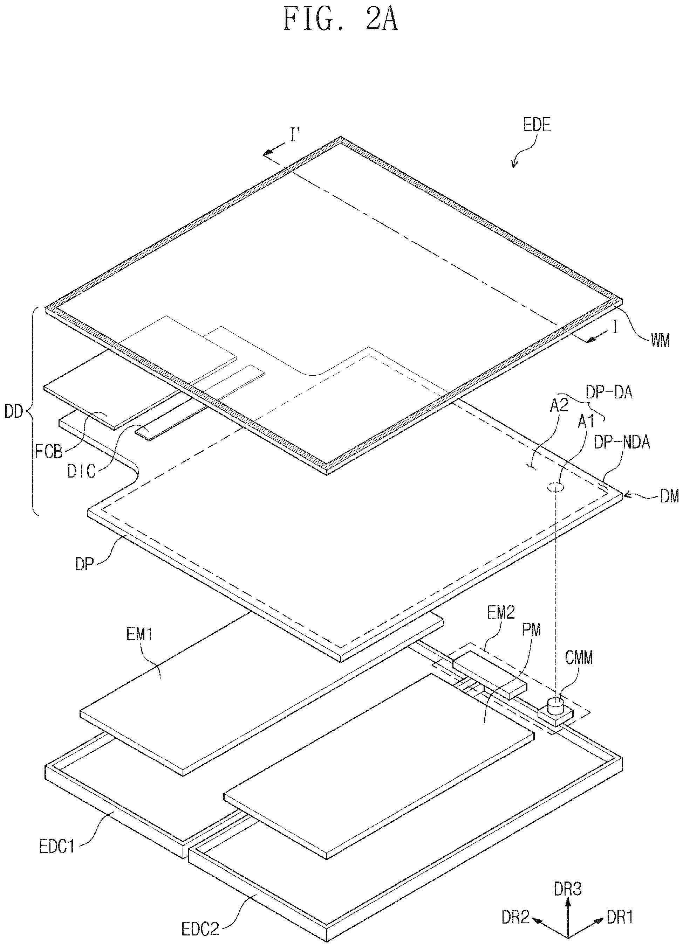

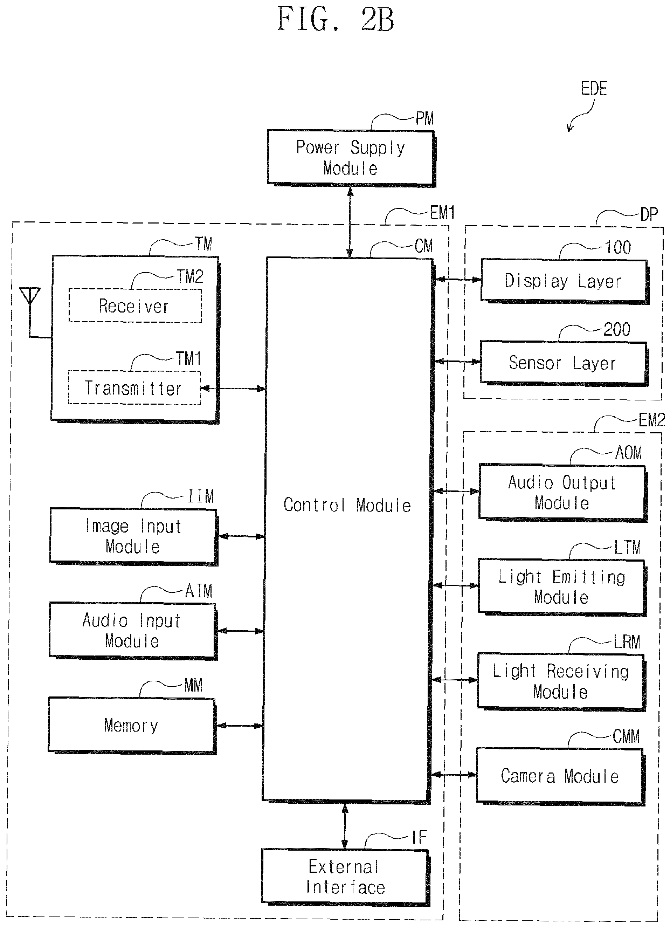

FIG. 2A is an exploded perspective view showing an embodiment of the electronic device EDE according to the disclosure. FIG. 2B is a block diagram showing an embodiment of the electronic device EDE according to the disclosure.

Referring to FIGS. 2A and 2B, the electronic device EDE may include a display device DD, a first electronic module EM1, a second electronic module EM2, a power supply module PM, and housings EDC1 and EDC2. Although not shown in drawing figures, the electronic device EDE may further include a mechanical structure to control a folding operation of the display device DD.

The display device DD may include a window module WM and a display module DM. The window module WM may provide a front surface of the electronic device EDE. The display module DM may include at least a display panel DP. The display module DM may generate the image IM (refer to FIG. 1A) and may sense the external input.

Although the display module DM is shown to be the same as the display panel DP in FIG. 2A, the display module DM may have a stack structure in which plural components including the display panel DP are stacked one on another. Detailed descriptions on the stack structure of the display module DM will be described later.

The display panel DP may include a display area DP-DA and a non-display area DP-NDA, which respectively correspond to the display area DA (refer to FIG. 1A) and the non-display area NDA (refer to FIG. 1A) of the electronic device EDE. In the disclosure, the expression "an area/portion corresponds to another area/portion" means that "an area/portion overlaps another area/portion", however, the "areas and portions" should not be limited to having the same size as each other.

The display area DP-DA may include a first area A1 and a second area A2. The first area A1 may overlap or correspond to the sensing area ED-SA (refer to FIG. 1A) of the electronic device EDE. In the illustrated embodiment, the first area A1 is shown as a circular shape, however, the shape of the first area A1 should not be limited thereto or thereby. The first area A1 may have a variety of shapes, such as a polygonal shape, an oval shape, a figure having at least one curved side, or an irregular shape. The first area A1 may be also referred to as a component area, and the second area A2 may be also referred to as a main display area or a normal display area.

The first area A1 may have a transmittance higher than that of the second area A2. In addition, the first area A1 may have a resolution lower than that of the second area A2, however, it should not be limited thereto or thereby. In an embodiment, the first area A1 may have the transmittance higher than that of the second area A2, however, the resolution of the first area A1 may be substantially the same as the resolution of the second area A2. The first area A1 may overlap a camera module CMM described later.

The display panel DP may include a display layer 100 and a sensor layer 200.

The display layer 100 may have a configuration that substantially generates the image IM. The display layer 100 may be a light-emitting type display layer. In an embodiment, the display layer 100 may be an organic light-emitting display layer, an inorganic light-emitting display layer, an organic-inorganic light-emitting display layer, a quantum dot display layer, a micro-light-emitting diode ("micro-LED") display layer, or a nano-LED display layer, for example.

The sensor layer 200 may sense an external input applied thereto from the outside. In an embodiment, the external input may be a user input, for example. The user input may include a variety of external inputs, such as at least a part of user's body, light, heat, an instrument (e.g., pen), or pressure.

The display module DM may further include a driving chip DIC disposed in the non-display area DP-NDA. The display module DM may further include a flexible circuit film FCB coupled with the non-display area DP-NDA.

The driving chip DIC may include driving elements, e.g., a data driving circuit, to drive pixels of the display panel DP. FIG. 2A shows a structure in which the driving chip DIC is disposed (e.g., mounted) on the display panel DP, however, the disclosure should not be limited thereto or thereby. In an embodiment, the driving chip DIC may be disposed (e.g., mounted) on the flexible circuit film FCB.

The power supply module PM may supply a power source desired for an overall operation of the electronic device EDE. The power supply module PM may include a well-known battery module.

The first electronic module EM1 and the second electronic module EM2 may include a variety of functional modules to drive the electronic device EDE. Each of the first electronic module EM1 and the second electronic module EM2 may be disposed (e.g., mounted) directly on a mother board, which is electrically connected to the display panel DP, or may be electrically connected to the mother board via a connector (not shown) after being disposed (e.g., mounted) on a separate substrate.

The first electronic module EM1 may include a control module CM, a wireless communication module TM, an image input module IIM, an audio input module AIM, a memory MM, and an external interface IF.

The control module CM may control an overall operation of the electronic device EDE. The control module CM may be, but not limited to, a microprocessor. In an embodiment, the control module CM may activate or deactivate the display panel DP, for example. The control module CM may control other modules, such as the image input module IIM or the audio input module AIM, based on a touch signal provided from the display panel DP.

The wireless communication module TM may communicate with an external electronic device through a first network, e.g., a short-range communication network such as Bluetooth, WiFi direct, or infrared data association ("IrDA"), or a second network, e.g., a long-range communication network such as a cellular network, an internet, or a computer network (e.g., a local area network ("LAN") or a wide area network ("WAN")). Communication modules included in the wireless communication module TM may be integrated into one component, e.g., a single chip, or may be implemented as a plurality of components separated from each other, e.g., a plurality of chips. The wireless communication module TM may transmit/receive a voice signal using a general communication line. The wireless communication module TM may include a transmitter TM1 that modulates a signal to be transmitted and transmits the modulated signal and a receiver TM2 that demodulates a signal applied thereto.

The image input module IIM may process an image signal and may convert the image signal into image data that may be displayed through the display panel DP. The audio input module AIM may receive an external sound signal through a microphone in a record mode or a voice recognition mode and may convert the external sound signal to electrical voice data.

The external interface IF may include a connector that physically connects the electronic device EDE to an external electronic device. In an embodiment, the external interface IF may serve as an interface between the control module CM and external devices, such as an external charger, a wired/wireless data port, a card (e.g., a memory card and a subscriber identity module/user identity module ("SIM/UIM") card), etc.

The second electronic module EM2 may include an audio output module AOM, a light-emitting module LTM, a light-receiving module LRM, and the camera module CMM. The audio output module AOM may convert audio data provided from the wireless communication module TM or audio data stored in the memory MM and may output the converted audio data to the outside.

The light-emitting module LTM may generate and emit a light. The light-emitting module LTM may emit an infrared light. The light-emitting module LTM may include an LED element. The light-receiving module LRM may sense the infrared light. The light-receiving module LRM may be activated when the infrared light above a predetermined level is sensed. The light-receiving module LRM may include a complementary metal oxide semiconductor ("CMOS") sensor. The infrared light generated and emitted from the light-emitting module LTM may be reflected by an external object, e.g., at least a portion of a user's body (e.g., finger or face), and the reflected infrared light may be incident into the light-receiving module LRM.

The camera module CMM may take a photo or video. The camera module CMM may be provided in plural. Among them, some camera modules CMM may overlap the first area A1. The external input, e.g., a light, may be provided to the camera module CMM via the first area A1. In an embodiment, the camera module CMM may receive a natural light through the first area A1 to take a picture of an external object.

The housings EDC1 and EDC2 may accommodate the display module DM, the first and second electronic modules EM1 and EM2, and the power supply module PM. The housings EDC1 and EDC2 may protect components accommodated therein, e.g., the display module DM, the first and second electronic modules EM1 and EM2, and the power supply module PM. FIG. 2A shows two housings EDC1 and EDC2 separated from each other as an illustrative embodiment, however, the disclosure should not be limited thereto or thereby. Although not shown in drawing figures, the electronic device EDE may further include a hinge structure to connect the two housings EDC1 and EDC2. The housings EDC1 and EDC2 may be coupled with the window module WM.

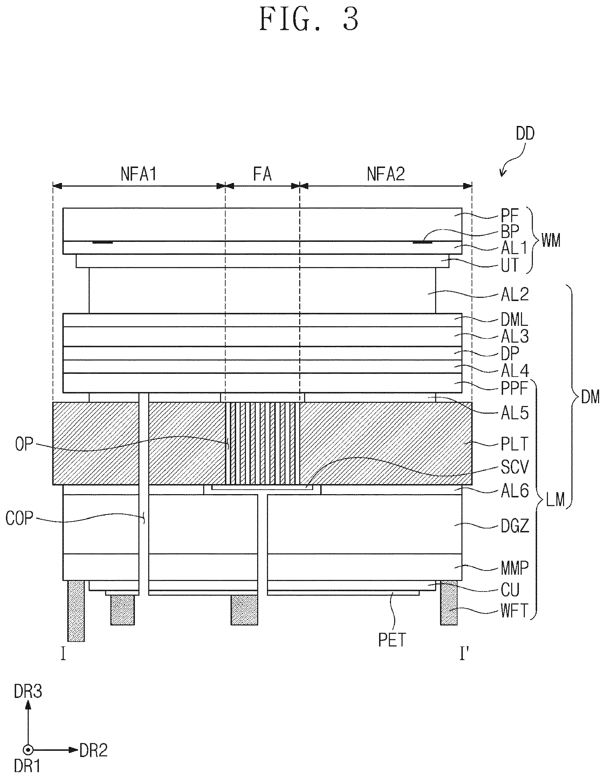

FIG. 3 is a cross-sectional view of an embodiment of the display device DD according to the disclosure. FIG. 3 is a cross-sectional view of an embodiment of the display device DD taken along line I-I' of FIG. 2A according to the disclosure.

Referring to FIG. 3, the display device DD may include the window module WM and the display module DM.

The window module WM may include a window UT, a protective film PF disposed on the window UT, and a bezel pattern BP.

The window UT may be a chemically strengthened glass. As the window UT is applied to the display device DD, the occurrence of crease may be minimized even though the folding and unfolding operations are repeatedly performed.

The protective film PF may include polyimide, polycarbonate, polyamide, triacetylcellulose, polymethylmethacrylate, or polyethylene terephthalate. Although not shown in drawing figures, at least one of a hard coating layer, an anti-fingerprint layer, and an anti-reflective layer may be disposed on an upper surface of the protective film PF.

The bezel pattern BP may overlap the non-display area NDA shown in FIG. 1A. The bezel pattern BP may be disposed on one surface of the window UT or one surface of the protective film PF. FIG. 3 shows the structure in which the bezel pattern BP is disposed on a lower surface of the protective film PF, however, it should not be limited thereto or thereby. In an embodiment, the bezel pattern BP may be disposed on an upper surface of the protective film PF, an upper surface of the window UT, or a lower surface of the window UT. The bezel pattern BP may be a coloured light-blocking layer and may be formed by a coating process. The bezel pattern BP may include a base material and a pigment or a dye mixed with the base material. The bezel pattern BP may have a closed line shape in a plan view.

A first adhesive layer AL1 may be disposed between the protective film PF and the window UT. The first adhesive layer AL1 may be a pressure sensitive adhesive ("PSA") film or an optically clear adhesive ("OCA") film. Adhesive layers described hereinafter may include the same adhesive as the first adhesive layer AL1 and may include a well-known adhesive.

The first adhesive layer AL1 may have a thickness sufficient to cover the bezel pattern BP. In an embodiment, the bezel pattern BP may have a thickness from about 3 micrometers to about 8 micrometers, and the first adhesive layer AL1 may have a thickness sufficient to prevent air bubbles from occurring around the bezel pattern BP.

The first adhesive layer AL1 may be separated from the window UT. Since a strength of the protective film PF is lower than that of the window UT, scratches may occur relatively easily on the protective film PF. After the first adhesive layer AL1 and the scratched protective film PF are separated from the window UT, another protective film PF may be attached to the window UT.

The display module DM may include an impact absorbing layer DML, the display panel DP, and a lower member LM.

The impact absorbing layer DML may be disposed above the display panel DP. The impact absorbing layer DML may be a functional layer to protect the display panel DP from the external impact. The impact absorbing layer DML may be coupled with the window UT by a second adhesive layer AL2 and may be coupled with the display panel DP by a third adhesive layer AL3.

The lower member LM may be disposed under the display panel DP. The lower member LM may include a panel protective layer PPF, a support layer PLT, a cover layer SCV, a digitizer DGZ, a shielding layer MMP, a heat dissipation layer CU, a protective layer PET, and a waterproof adhesive (e.g., waterproof tape) WFT. In an embodiment, the lower member LM may not include some of the above-mentioned components or may further include other components. In addition, the stacking order shown in FIG. 3 is merely one of embodiments, and the stacking order of the components may be changed.

The panel protective layer PPF may be disposed under the display panel DP. The panel protective layer PPF may be attached to a rear surface of the display panel DP by a fourth adhesive layer AL4. The panel protective layer PPF may protect a lower portion of the display panel DP. The panel protective layer PPF may include a flexible plastic material. The panel protective layer PPF may prevent scratches from occurring on the rear surface of the display panel DP during a manufacturing process of the display panel DP. The panel protective layer PPF may be a coloured polyimide film. In an embodiment, the panel protective layer PPF may be an opaque yellow film, for example, however, it should not be limited thereto or thereby.

The support layer PLT may be disposed under the panel protective layer PPF. The support layer PLT may support components disposed on the support layer PLT and may maintain the unfolded state and the folded state of the display device DD. In an embodiment, the support layer PLT may include at least a first support portion corresponding to the first non-folding area NFA1, a second support portion corresponding to the second non-folding area NFA2, and a folding portion corresponding to the folding area FA. The first support portion and the second support portion may be spaced apart from each other in the second direction DR2. The folding portion may be disposed between the first support portion and the second support portion and a plurality of openings OP may be defined through the folding portion. Due to the openings OP, a flexibility of a portion of the support layer PLT may be improved. The flexibility of the portion of the support layer PLT, which overlaps the folding area FA, may be improved by the openings OP.

The support layer PLT may include a carbon fiber reinforced plastic ("CFRP"), however, it should not be limited thereto or thereby. In an embodiment, the first and second support portions may include a non-metallic material, a plastic material, a glass fiber reinforced plastic, or a glass material. The plastic material may include polyimide, polyethylene, or polyethylene terephthalate, however, it should not be particularly limited. The first support portion and the second support portion may include the same material as each other. The folding portion may include the same material as that of the first support portion and the second support portion or may include a different material from that of the first support portion and the second support portion. In an embodiment, the folding portion may include a material having an elastic modulus equal to or greater than about 60 gigapascals (GPa) and may include a metal material such as a stainless steel. In an embodiment, the folding portion may include SUS 304, for example, however, it should not be limited thereto or thereby. The folding portion may include a variety of metal materials.

The support layer PLT may be attached to the panel protective layer PPF by a fifth adhesive layer AL5. The fifth adhesive layer AL5 may be provided in plural, and the fifth adhesive layers AL5 may be spaced apart from each other with the folding area FA interposed therebetween. The fifth adhesive layer AL5 may not overlap the openings OP. In addition, the fifth adhesive layer AL5 may be spaced apart from the openings OP in the plan view. As the fifth adhesive layer AL5 is not disposed in an area corresponding to the folding area FA, the flexibility of the support layer PLT may be improved.

In the area overlapping the folding area FA, the panel protective layer PPF may be spaced apart from the support layer PLT. That is, an empty space may be defined between the support layer PLT and the panel protective layer PPF in the area overlapping the folding area FA. Since the empty space is defined between the panel protective layer PPF and the support layer PLT, the openings OP defined through the support layer PLT may not be viewed from the outside of the electronic device EDE (refer to FIG. 1A).

The fifth adhesive layer AL5 may have a thickness smaller than a thickness of the fourth adhesive layer AL4. In the description, a thickness may mean a length measured in the third direction DR3. In an embodiment, the thickness of the fourth adhesive layer AL4 may be about 25 micrometers, and the thickness of the fifth adhesive layer AL5 may be about 16 micrometers. As the thickness of the fifth adhesive layer AL5 decreases, a step difference caused by the fifth adhesive layer AL5 may decrease. When the step difference decreases, there is an advantage in that a deformation of the stack structure due to the folding and unfolding operations of the electronic device EDE (refer to FIG. 1A) may be reduced, but the openings OP may be viewed or the fifth adhesive layer AL5 may be detached due to the repeated folding operations. As the thickness of the fifth adhesive layer AL5 increases, the openings OP may not be viewed and reliability with respect to an adhesive force of the fifth adhesive layer AL5 may be improved in spite of the repeated folding operations, however, the step difference may increase. Accordingly, the thickness of the fifth adhesive layer AL5 may be determined to be within an appropriate range in consideration of a folding reliability, an adhesion reliability, and a visibility of the openings OP.

The cover layer SCV may be disposed under the support layer PLT. The cover layer SCV may be coupled with the support layer PLT by an adhesive layer. The cover layer SCV may cover the openings OP defined through the support layer PLT. Accordingly, the cover layer SCV may prevent a foreign substance from entering the openings OP. The cover layer SCV may have an elastic modulus smaller than that of the support layer PLT. In an embodiment, the cover layer SCV may include thermoplastic polyurethane, rubber, or silicone, however, it should not be limited thereto or thereby.

The digitizer DGZ may be disposed under the support layer PLT. In an embodiment, the digitizer DGZ may be attached to the support layer PLT by a sixth adhesive layer AL6. The digitizer DGZ may be provided in plural. In an embodiment, the digitizers DGZ may be spaced apart from each other in the second direction DR2. In a plan view, a portion of each of the digitizers DGZ may overlap the non-folding area NFA1 or NFA2, and the other portions of each of the digitizers DGZ may overlap the folding area FA. In the plan view, a portion of each of the digitizers DGZ may overlap a portion of the openings OP.

Each of the digitizers DGZ may include a plurality of loop coils generating a magnetic field with an input device, e.g., a pen, at a predetermined resonant frequency. The digitizers DGZ may be referred to as an EMR sensing panel.

The magnetic field generated by the digitizers DGZ may be applied to an inductor-capacitor ("LC") resonant circuit formed by an inductor (coil) and a capacitor of the instrument (e.g., pen). The coil may generate a current in response to the magnetic field applied thereto and may supply the generated current to the capacitor. Accordingly, the capacitor may be charged with the current supplied thereto from the coil and may discharge the charged current to the coil. Consequently, the magnetic field of the resonant frequency may be emitted from the coil. The magnetic field emitted by the instrument (e.g., pen) may be absorbed by the loop coils of the digitizers DGZ, and thus, it is possible to determine a position in the digitizers DGZ to which the instrument (e.g., pen) gets close.

The shielding layers MMP may be disposed under the digitizers DGZ, respectively. Each of the shielding layers MMP may include a magnetic metal powder. The shielding layers MMP may be also referred to as a magnetic metal powder layer, a magnetic layer, a magnetic circuit layer, or a magnetic path layer. The shielding layers MMP may shield a magnetic field.

The heat dissipation layers CU may be disposed under the shielding layers MMP, respectively. The heat dissipation layers CU may be sheets with a substantially high heat conductivity. In an embodiment, each of the heat dissipation layers CU may include graphite, copper, or copper alloy, however, it should not be particularly limited.

The protective layers PET may be disposed under the heat dissipation layers CU, respectively. The protective layers PET may be insulating layers. In an embodiment, the protective layers PET may prevent a static electricity from entering. Accordingly, an electrical interference may be prevented from occurring between the flexible circuit film FCB (refer to FIG. 2A) and members disposed on the protective layers PET by the protective layers PET.

The waterproof adhesives WFT may be attached to the shielding layers MMP and the protective layers PET. The waterproof adhesive WFT may be attached to a set bracket (not shown). Among the waterproof adhesives WFT, the waterproof adhesives WFT attached to the shielding layers MMP may have a thickness different from a thickness of the waterproof adhesives WFT attached to the protective layers PET.

A through hole COP may be defined through at least some components of the lower member LM. The through hole COP may overlap or correspond to the sensing area ED-SA (refer to FIG. 1A) of the electronic device EDE. At least a portion of the camera module CMM (refer to FIG. 2A) may be inserted into the through hole COP.

FIG. 3 shows a structure in which the through hole COP is defined from a rear surface of one protective layer PET among the protective layers PET to the fifth adhesive layer AL5 as an illustrative embodiment, however, the disclosure should not be limited thereto or thereby. In an embodiment, the through hole COP may be defined from the rear surface of the one protective layer PET to an upper surface of the panel protective layer PPF or from the rear surface of the one protective layer PET to an upper surface of the fourth adhesive layer AL4.

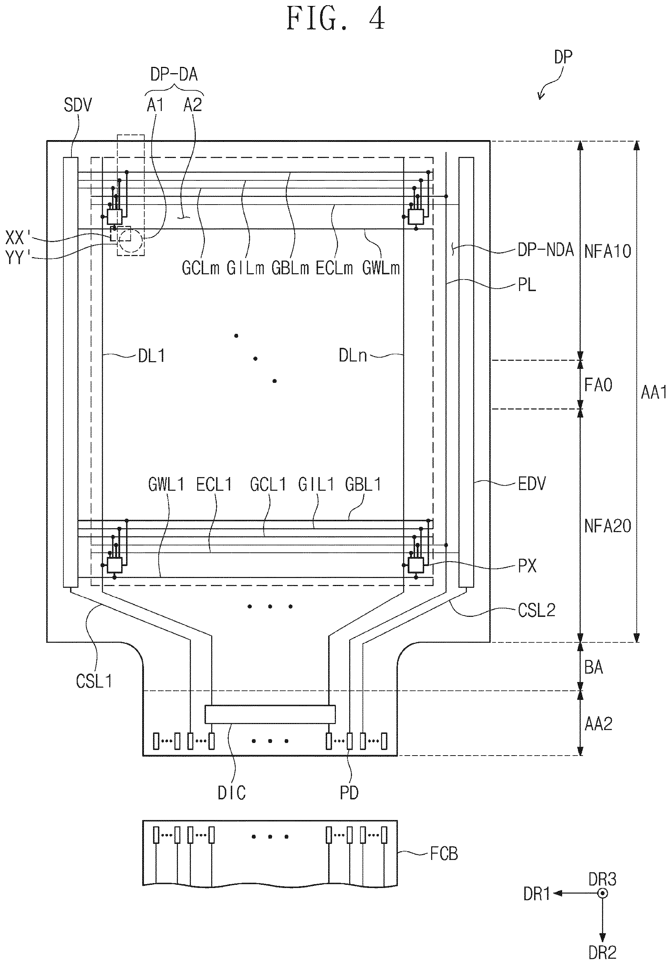

FIG. 4 is a plan view of an embodiment of the display panel DP according to the disclosure.

Referring to FIG. 4, the display panel DP may include the display area DP-DA and the non-display area DP-NDA around the display area DP-DA. The display area DP-DA and the non-display area DP-NDA may be distinguished from each other by a presence or absence of the pixel PX. The pixel PX may be disposed in the display area DP-DA. A scan driver SDV, a data driver, and an emission driver EDV may be disposed in the non-display area DP-NDA. The data driver may be a circuit provided in the driving chip DIC.

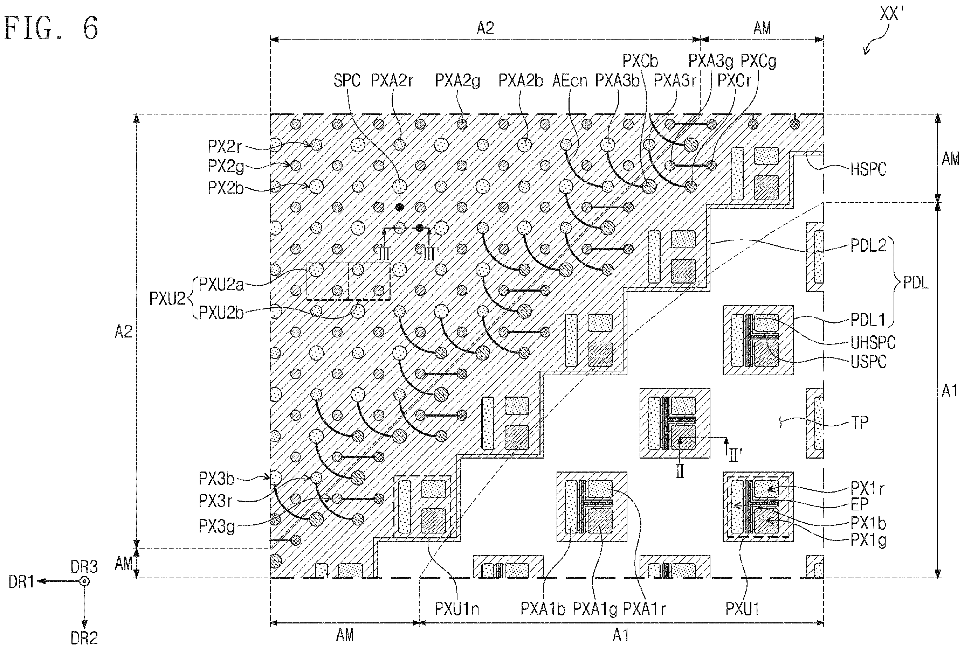

The display area DP-DA may include the first area A1 and the second area A2. The first area A1 and the second area A2 may be distinguished from each other by an arrangement interval of the pixels PX, a size of the pixels PX, a shape of the pixels PX, or a presence or absence of a transmission area TP (refer to FIG. 6). The first area A1 and the second area A2 will be described in detail later.

The display panel DP may include a first panel area AA1, a bending area BA, and a second panel area AA2, which are defined in the second direction DR2. The second panel area AA2 and the bending area BA may be areas of the non-display area DP-NDA. The bending area BA may be defined between the first panel area AA1 and the second panel area AA2.

The first panel area AA1 may correspond to the display surface DS of FIG. 1A. The first panel area AA1 may include a first non-folding area NFA10, a second non-folding area NFA20, and a folding area FA0. The first non-folding area NFA10, the second non-folding area NFA20, and the folding area FA0 may respectively correspond to the first non-folding area NFA1, the second non-folding area NFA2, and the folding area FA of FIGS. 1A and 1B.

A width (or a length) in the first direction DR1 of the bending area BA and a width (or a length) in the first direction DR1 of the second panel area AA2 may be smaller than a width (or a length) in the first direction DR1 of the first panel area AA1. An area having a relatively short length in a bending axis direction may be relatively easily bent.

The display panel DP may include the pixels PX, a plurality of initialization scan lines GIL1 to GILm, a plurality of compensation scan lines GCL1 to GCLm, a plurality of write scan lines GWL1 to GWLm, a plurality of black scan lines GBL1 to GBLm, a plurality of emission control lines ECL1 to ECLm, a plurality of data lines DL1 to DLn, first and second control lines CSL1 and CSL2, a driving voltage line PL, and a plurality of pads PD. In the illustrated embodiment, each of "m" and "n" is a natural number equal to or greater than 2.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, the data lines DL1 to DLn, and the driving voltage line PL.

The initialization scan lines GIL1 to GILm, the compensation scan lines GCL1 to GCLm, the write scan lines GWL1 to GWLm, and the black scan lines GBL1 to GBLm may extend in a direction opposite to the first direction DR1 and may be electrically connected to the scan driver SDV. The data lines DL1 to DLn may extend in the second direction DR2 and may be electrically connected to the driving chip DIC via the bending area BA. The emission control lines ECL1 to ECLm may extend in the first direction DR1 and may be electrically connected to the emission driver EDV.

The driving voltage line PL may include a portion extending in the first direction DR1 and a portion extending in the second direction DR2. The portion extending in the first direction DR1 and the portion extending in the second direction DR2 may be disposed in different layers from each other. The portion of the driving voltage line PL, which extends in the second direction DR2, may extend to the second panel area AA2 via the bending area BA. The driving voltage line PL may provide a driving voltage to the pixels PX.

The first control line CSL1 may be connected to the scan driver SDV and may extend to a lower end of the second panel area AA2 via the bending area BA. The second control line CSL2 may be connected to the emission driver EDV and may extend to the lower end of the second panel area AA2 via the bending area BA.

In a plan view, the pads PD may be disposed adjacent to the lower end of the second panel area AA2. The driving chip DIC, the driving voltage line PL, the first control line CSL1, and the second control line CSL2 may be electrically connected to the pads PD. The flexible circuit film FCB may be electrically connected to the pads PD through an anisotropic conductive adhesive layer.

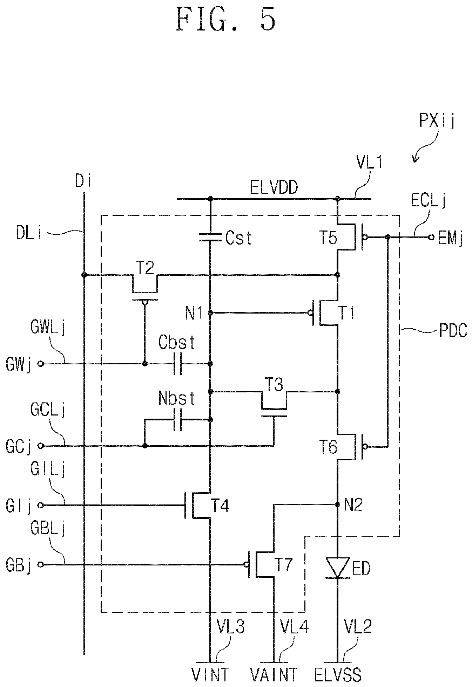

FIG. 5 is an equivalent circuit diagram of an embodiment of a pixel PXij according to the disclosure.

FIG. 5 shows an equivalent circuit diagram of the pixel PXij among the pixels PX (refer to FIG. 4). Since the pixels PX may have substantially the same configuration as each other, the circuit configuration of the pixel PXij will be described in detail, and detailed descriptions of the other pixels will be omitted.

Referring to FIGS. 4 and 5, the pixel PXij may be connected to an i-th data line DLi among data lines DL1 to DLn, a j-th initialization scan line GILj among the initialization scan lines GIL1 to GILm, a j-th compensation scan line GCLj among the compensation scan lines GCL1 to GCLm, a j-th write scan line GWLj among the write scan lines GWL1 to GWLm, a j-th black scan line GBLj among the black scan lines GBL1 to GBLm, a j-th emission control line ECLj among the emission control lines ECL1 to ECLm, first and second driving voltage lines VL1 and VL2, and first and second initialization voltage lines VL3 and VL4. Here, "i" may be an integer number equal to or greater than 1 and equal to or smaller than n, and " j" may be an integer number equal to or greater than 1 and equal to or smaller than m.

The pixel PXij may include a light-emitting element ED and a pixel circuit PDC. The light-emitting element ED may be a light-emitting diode. In an embodiment, the light-emitting element ED may be an organic light-emitting diode including an organic light-emitting layer, however, it should not be particularly limited. The pixel circuit PDC may control an amount of current flowing through the light-emitting element ED in response to the data signal i-th Di. The light-emitting element ED may emit a light with a predetermined luminance corresponding to the amount of current provided from the pixel circuit PDC.

The pixel circuit PDC may include first, second, third, fourth, fifth, sixth, and seventh transistors T1, T2, T3, T4, T5, T6, and T7 and first, second, and third capacitors Cst, Cbst, and Nbst. The configuration of the pixel circuit PDC should not be limited to the embodiment shown in FIG. 5. The pixel circuit PDC shown in FIG. 5 is merely one of embodiments, and the configuration of the pixel circuit PDC may be changed.

In the illustrated embodiment, at least one of the first to seventh transistors T1 to T7 may include a low-temperature polycrystalline silicon ("LTPS") as its semiconductor layer. At least one of the first to seventh transistors T1 to T7 may include an oxide material as its semiconductor layer. In an embodiment, each of the third and fourth transistors T3 and T4 may be an oxide semiconductor transistor, and each of the first, second, fifth, sixth, and seventh transistors T1, T2, T5, T6, and T7 may be an LTPS transistor.

In detail, the first transistor T1, which directly affects the luminance of the light-emitting element ED, may include the semiconductor layer including or consisting of polycrystalline silicon with substantially high reliability, and thus, the display device with substantially high resolution may be implemented. Since the oxide semiconductor has a substantially high carrier mobility and a substantially low leakage current, the voltage drop is not substantially large even though the driving time is long. That is, even when the pixels PX are driven at substantially low frequency, a change in colour of the image due to the voltage drop is not large, and thus, the pixels PX may be driven at substantially low frequency. As described above, since the oxide semiconductor has substantially low leakage current, at least one of the third transistor T3 and the fourth transistor T4, which are connected to a gate electrode of the first transistor T1, may include the oxide semiconductor. Thus, the leakage current may be prevented from flowing to the gate electrode of the first transistor T1, and power consumption may be reduced.

Some of the first to seventh transistors T1 to T7 may be a P-type transistor, and the other of the first to seventh transistors T1 to T7 may be an N-type transistor. In an embodiment, each of the first, second, fifth, sixth, and seventh transistors T1, T2, T5, T6, and T7 may be the P-type transistor, and each of the third and fourth transistors T3 and T4 may be the N-type transistor.

The configuration of the pixel circuit PDC should not be limited to that shown in FIG.5. The pixel circuit PDC shown in FIG. 5 is merely one of embodiments, and the configuration of the pixel circuit PDC may be changed. In an embodiment, all the first to seventh transistors T1 to T7 may be the P-type transistor or the N-type transistor. In an embodiment, the first, second, fifth, and sixth transistors T1, T2, T5, and T6 may be the P-type transistor, and the third, fourth, and seventh transistors T3, T4, and T7 may be the N-type transistor.

The j-th initialization scan line GILj, the j-th compensation scan line GCLj, the j-th write scan line GWLj, the j-th black scan line GBLj, and the j-th emission control line ECLj may transmit a j-th initialization scan signal GIj, a j-th compensation scan signal GCj, a j-th write scan signal GWj, a j-th black scan signal GBj, and a j-th emission control signal EMj to the pixel PXij, respectively. The i-th data line DLi may transmit an i-th data signal Di to the pixel PXij. The i-th data signal Di may have a voltage level corresponding to the image signal input to the display device DD (refer to FIG. 3).

The first and second driving voltage lines VL1 and VL2 may transmit a first driving voltage ELVDD and a second driving voltage ELVSS to the pixel PXij, respectively. In addition, the first and second initialization voltage lines VL3 and VL4 may transmit a first initialization voltage VINT and a second initialization voltage VAINT to the pixel PXij, respectively.

The first transistor T1 may be connected between the first driving voltage line VL1 receiving the first driving voltage ELVDD and the light-emitting element ED. The first transistor T1 may include a first electrode connected to the first driving voltage line VL1 via the fifth transistor T5, a second electrode electrically connected to a pixel electrode (or referred to as an anode) of the light-emitting element ED via the sixth transistor T6, and a third electrode (e.g., the gate electrode) connected to one end (e.g., a first node N1) of the first capacitor Cst. The first transistor T1 may receive the i-th data signal Di transmitted by the i-th data line DLi according to a switching operation of the second transistor T2 and may supply a driving current to the light-emitting element ED.

The second transistor T2 may be connected between the i-th data line DLi and the first electrode of the first transistor T1. The second transistor T2 may include a first electrode connected to the i-th data line DLi, a second electrode connected to the first electrode of the first transistor T1, and a third electrode (e.g., a gate electrode) connected to the j-th write scan line GWLj. The second transistor T2 may be turned on in response to the j-th write scan signal GWj applied thereto via the j-th write scan line GWLj and may transmit the i-th data signal Di applied thereto via the i-th data line DLi to the first electrode of the first transistor T1. One end of the second capacitor Cbst may be connected to the third electrode of the second transistor T2, and the other end of the second capacitor Cbst may be connected to the first node N1.

The third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj applied thereto via the j-th compensation scan line GCLj and may connect the third electrode and the second electrode of the first transistor T1 to each other to allow the first transistor T1 to be connected in a diode configuration. One end of the third capacitor Nbst may be connected to the third electrode of the third transistor T3, and the other end of the third capacitor Nbst may be connected to the first node N1.

The fourth transistor T4 may be connected between the first initialization voltage line VL3 to which the first initialization voltage VINT is applied and the first node N1. The fourth transistor T4 may include a first electrode connected to the first initialization voltage line VL3 to which the first initialization voltage VINT is applied, a second electrode connected to the first node N1, and a third electrode (e.g., a gate electrode) connected to the j-th initialization scan line GILj. The fourth transistor T4 may be turned on in response to the j-th initialization scan signal GIj applied thereto via the j-th initialization scan line GILj. The turned-on fourth transistor T4 may transmit the first initialization voltage VINT to the first node N1 to initialize an electric potential of the third electrode of the first transistor T1, i.e., an electric potential of the first node N1.

The fifth transistor T5 may include a first electrode connected to the first driving voltage line VL1, a second electrode connected to the first electrode of the first transistor T1, and a third electrode (e.g., a gate electrode) connected to the j-th emission control line ECLj. The sixth transistor T6 may include a first electrode connected to the second electrode of the first transistor T1, a second electrode connected to the pixel electrode of the light-emitting element ED, and a third electrode (e.g., a gate electrode) connected to the j-th emission control line ECLj.

The fifth transistor T5 and the sixth transistor T6 may be substantially simultaneously turned on in response to the j-th emission control signal EMj applied thereto via the j-th emission control line ECLj. The first driving voltage ELVDD applied via the turned-on fifth transistor T5 may be compensated for by the first transistor T1 connected in the diode configuration and may be transmitted to the light-emitting element ED via the sixth transistor T6.

The seventh transistor T7 may include a first electrode connected to the second initialization voltage line VL4 to which the second initialization voltage VAINT is applied, a second electrode connected to the second electrode of the sixth transistor T6, i.e., a second node N2 between the sixth transistor T6 and the light-emitting element ED, and a third electrode (e.g., a gate electrode) connected to the j-th black scan line GBLj. The second initialization voltage VAINT may have a voltage level equal to or lower than that of the first initialization voltage VINT.

The one end of the first capacitor Cst may be connected to the third electrode of the first transistor T1, and the other end of the first capacitor Cst may be connected to the first driving voltage line VL1. A common electrode (or be referred to as a cathode) of the light-emitting element ED may be connected to the second driving voltage line VL2 that transmits the second driving voltage ELVSS. The second driving voltage ELVSS may have a voltage level lower than that of the first driving voltage ELVDD.

FIG. 6 is an enlarged plan view of a portion of the display panel DP according to the disclosure. FIG. 6 is an enlarged plan view of an area XX' shown in FIG. 4.

Referring to FIGS. 4 and 6, the display panel DP may include the first area A1, the second area A2, and a boundary area AM defined between the first area A1 and the second area A2.

The pixel PX may be provided in plural, and the pixels PX may include first pixels PX1r, PX1g, and PX1b, second pixels PX2r, PX2g, and PX2b, and third pixels PX3r, PX3g, and PX3b. The first pixels PX1r, PX1g, and PX1b may be disposed in the first area A1 and the boundary area AM. The second pixels PX2r, PX2g, and PX2b may be disposed in the second area A2. The third pixels PX3r, PX3g, and PX3b may be disposed in the boundary area AM or may be disposed over the second area A2 and the boundary area AM.

The number of the first pixels PX1r, PX1g, and PX1b disposed in the first area A1 per reference area may be smaller than the number of the second pixels PX2r, PX2g, and PX2b disposed in the second area A2 per reference area. Accordingly, a resolution of the first area A1 may be lower than a resolution of the second area A2.

The first pixels PX1r, PX1g, and PX1b may include a first-first colour pixel PX1r, a first-second colour pixel PX1g, and a first-third colour pixel PX1b. The second pixels PX2r, PX2g, and PX2b may include a second-first colour pixel PX2r, a second-second colour pixel PX2g, and a second-third colour pixel PX2b. The third pixels PX3r, PX3g, and PX3b may include a third-first colour pixel PX3r, a third-second colour pixel PX3g, and a third-third colour pixel PX3b. The first-first colour pixel PX1r, the second-first colour pixel PX2r, and the third-first colour pixel PX3r may be red light-emitting pixels. The first-second colour pixel PX1g, the second-second colour pixel PX2g, and the third-second colour pixel PX3g may be green light-emitting pixels. The first-third colour pixel PX1b, the second-third colour pixel PX2b, and the third-third colour pixel PX3b may be blue light-emitting pixels.

Each of the first pixels PX1r, PX1g, and PX1b, the second pixels PX2r, PX2g, and PX2b, and the third pixels PX3r, PX3g, and PX3b shown in FIG. 6 may have a shape corresponding to that of the light-emitting area defined in the light-emitting element ED (refer to FIG. 5) in the plan view. The light-emitting area may be defined by a pixel definition opening defined through a pixel definition layer PDL.

FIG. 6 shows first light-emitting areas PXA1r, PXA1g, and PXA1b respectively corresponding to the first pixels PX1r, PX1g, and PX1b and second light-emitting areas PXA2r, PXA2g, and PXA2b respectively corresponding to the second pixels PX2r, PX2g, and PX2b. In FIG. 6, a third-first light-emitting area PXA3r and a third-first copy light-emitting area PXCr corresponding to the third-first colour pixel PX3r, a third-second light-emitting area PXA3g and a third-second copy light-emitting area PXCg corresponding to the third-second colour pixel PX3g, and a third-third light-emitting area PXA3b and a third-third copy light-emitting area PXCb corresponding to the third-third colour pixel PX3b are shown.

A first-first light-emitting area PXA1r may have a size greater than a size of a second-first light-emitting area PXA2r, a first-second light-emitting area PXA1g may have a size greater than a size of a second-second light-emitting area PXA2g, and a first-third light-emitting area PXA1b may have a size greater than a size of a second-third light-emitting area PXA2b. When a constant brightness is implemented within the reference area, the size of each of the first pixels PX1r, PX1g, and PX1b, which is desired to emit relatively bright light, may be provided larger than the size of each of the second pixels PX2r, PX2g, and PX2b, and thus, a lifespan of the first pixels PX1r, PX1g, and PX1b may be compensated.

The emission of the third-first light-emitting area PXA3r and the emission of the third-first copy light-emitting area PXCr may be controlled by the operation of the same pixel circuit. Accordingly, the third-first light-emitting area PXA3r and the third-first copy light-emitting area PXCr may or may not provide the light substantially simultaneously. FIG. 6 shows a connection electrode AEcn to clarify a relationship between the third-first light-emitting area PXA3r and the third-first copy light-emitting area PXCr. The emission of the third-second light-emitting area PXA3g and the emission of the third-second copy light-emitting area PXCg may be controlled by the operation of the same pixel circuit, and the emission of the third-third light-emitting area PXA3b and the emission of the third-third copy light-emitting area PXCb may be controlled by the operation of the same pixel circuit.

Each of the third pixels PX3r, PX3g, and PX3b may include the plural light-emitting areas. In an embodiment, the third-first colour pixel PX3r may include the third-first light-emitting area PXA3r and the third-first copy light-emitting area PXCr, the third-second colour pixel PX3g may include the third-second light-emitting area PXA3g and the third-second copy light-emitting area PXCg, and the third-third colour pixel PX3b may include the third-third light-emitting area PXA3b and the third-third copy light-emitting area PXCb.

It is difficult to place the pixel circuit PDC (refer to FIG. 5) in the boundary between the first area A1 and the second area A2 due to space limitations. In an embodiment, an area in which the third-first copy light-emitting area PXCr, the third-second copy light-emitting area PXCg, and the third-third copy light-emitting area PXCb are arranged may be the boundary area AM where it is difficult to place the pixel circuit PDC due to space limitations. Accordingly, the copy light-emitting elements that do not include the pixel circuit PDC may be arranged in the boundary area AM. Therefore, as the light-emitting areas providing the light are additionally provided in the boundary area AM, the boundary between the first area A1 and the second area A2 may be prevented from being perceived as dark.

FIG. 6 shows the pixel definition layer PDL. The pixel definition layer PDL may include pixel definition patterns PDL1 and a pixel definition film PDL2.

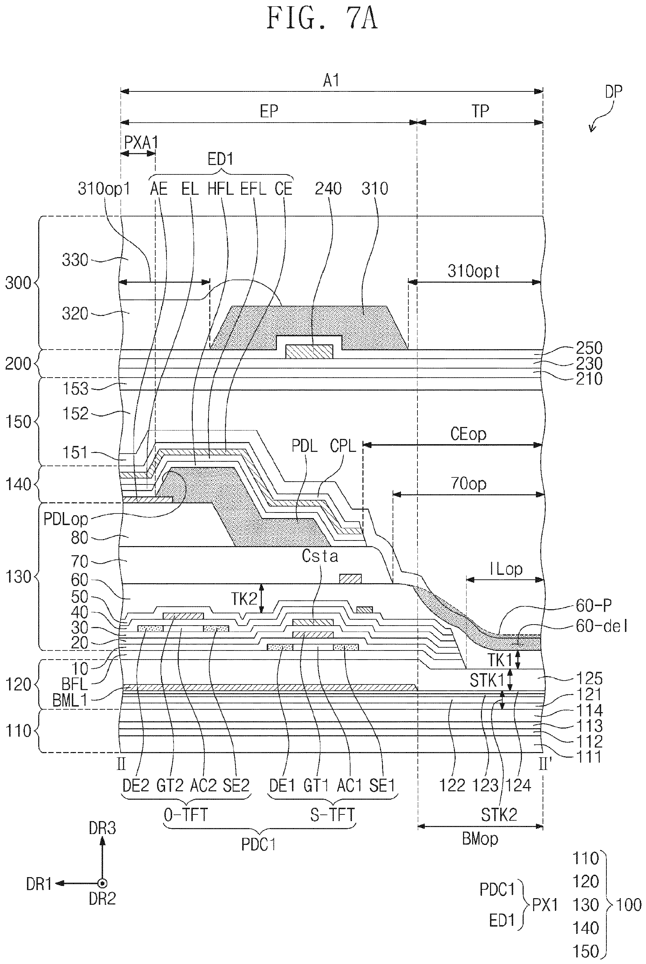

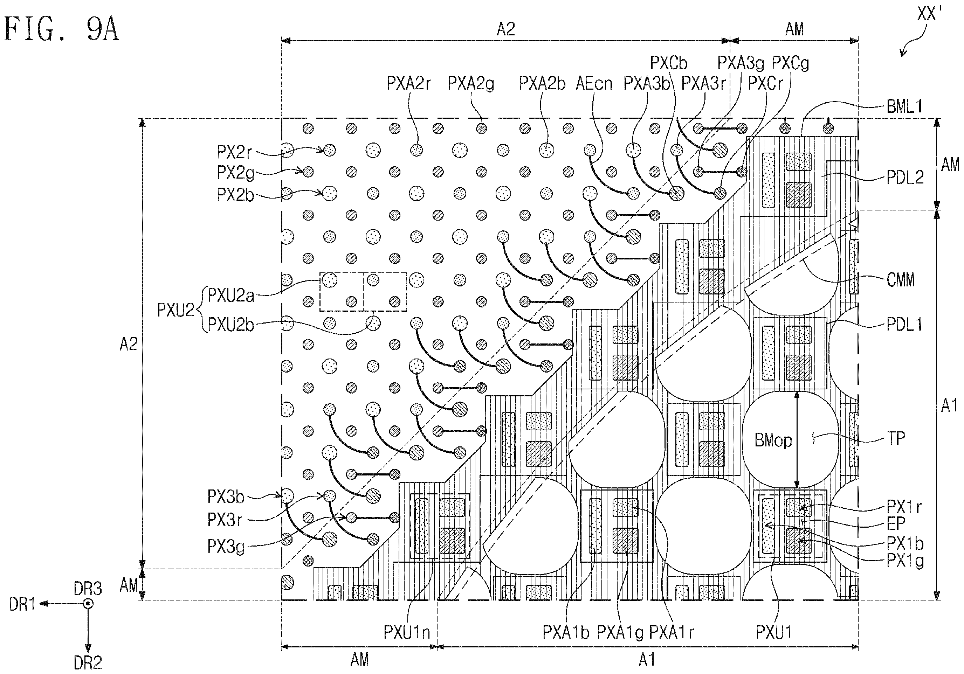

The pixel definition patterns PDL1 may be disposed in the first area A1 and may be spaced apart from each other. In an embodiment, the first area A1 may include transmission areas TP and an element area EP, and the pixel definition patterns PDL1 may not overlap the transmission areas TP and may overlap the element area EP. A boundary between the transmission areas TP and the element area EP may be defined by a first lower light-blocking layer BML1 (refer to FIG. 7A), and details thereof will be described with reference to FIG. 9A. At least three pixel definition openings may be defined through each of the pixel definition patterns PDL1. In an embodiment, the openings corresponding to the first light-emitting areas PXA1r, PXA1g, and PXA1b, respectively, may be defined in each of the pixel definition patterns PDL1.

A first pixel unit PXU1 may be disposed in the first area A1, a second pixel unit PXU2 may be disposed in the first area A2, and a boundary pixel unit PXUin may be disposed in the boundary area AM. The second pixel unit PXU2 may include a first sub-pixel unit PXU2a and a second sub-pixel unit PXU2b. Each of the first pixel unit PXU1 and the boundary pixel unit PXUin may include the first pixels PX1r, PX1g, and PX1b. In addition, shapes of the first light-emitting areas PXA1r, PXA1g, and PXA1b corresponding to the first pixel unit PXU1 may be substantially the same as shapes of the first light-emitting areas PXA1r, PXA1g, and PXA1b corresponding to the boundary pixel unit PXU1n.

The first pixel unit PXU1 may be disposed between four transmission areas TP. The boundary pixel unit PXUin may be disposed between the transmission areas TP disposed at an outermost position of the first area A1 among the transmission areas TP and the second area A2. Accordingly, the boundary pixel unit PXUin may be disposed adjacent to two transmission areas TP or three transmission areas TP.

The pixel definition film PDL2 may cover the second area A2 and a portion of the boundary area AM. In an embodiment, the pixel definition film PDL2 may cover the portion of the boundary area AM in which the boundary pixel unit PXUin is disposed. Pixel definition openings corresponding to the first light-emitting areas PXA1r, PXA1g, and PXA1b of the boundary pixel unit PXU1n, pixel definition openings corresponding to the second light-emitting areas PXA2r, PXA2g, and PXA2b, and pixel definition openings corresponding to the third-first light-emitting area PXA3r, the third-first copy light-emitting area PXCr, the third-second light-emitting area PXA3g, the third-second copy light-emitting area PXCg, the third-third light-emitting area PXA3b, and the third-third copy light-emitting area PXCb may be defined in the pixel definition film PDL2.

FIG. 6 shows a first spacer HSPC, a first protruded spacer SPC, a second spacer UHSPC, and a second protruded spacer USPC.

The first spacer HSPC may be disposed on the pixel definition film PDL2. Similar to the pixel definition film PDL2, the first spacer HSPC may cover the second area A2 and a portion of the boundary area AM. In an embodiment, the first spacer HSPC may cover the portion of the boundary area AM in which the boundary pixel unit PXUin is disposed. In addition, the first spacer HSPC may cover a portion of the boundary area AM in which the third-first copy light-emitting area PXCr, the third-second copy light-emitting area PXCg, and the third-third copy light-emitting area PXCb are arranged. As the first spacer HSPC is also provided in the boundary area AM, adhesive properties between layers of the display panel DP may be strengthened or improved. The first protruded spacer SPC may be disposed on the first spacer HSPC. The first protruded spacer SPC may have a circular shape in the plan view. The first protruded spacer SPC may be disposed in the second area A2. The first protruded spacer SPC may not be disposed in the boundary area AM. The first protruded spacer SPC may be provided only between the second pixels PX2r, PX2g, and PX2b and may not be provided between the third-first copy light-emitting area PXCr, the third-second copy light-emitting area PXCg, and the third-third copy light-emitting area PXCb.

The first protruded spacer SPC may have a height or thickness greater than a height or thickness of the first spacer HSPC. The height of the first spacer HSPC may be within a range from about 0.1 micrometer (*µ*m) to about 0.5*µ*m, and a sum of the height of the first spacer HSPC and the height of the first protruded spacer SPC may be within a range from about 1.1*µ*m to about 2.0*µ*m. However, the height of the first spacer HSPC and the sum of the height of the first spacer HSPC and the height of the first protruded spacer SPC should not be limited thereto or thereby.

The first protruded spacer SPC may be provided in plural. In an embodiment, two first protruded spacers SPC may be disposed adjacent to one second-second colour pixel PX2g. In this case, the probability of occurrence of dent defects caused by a mask during a manufacturing process may be further reduced.

Two first protruded spacers SPC and four second-second colour pixels PX2g may be repeatedly arranged. In an embodiment, two first protruded spacers SPC may be spaced apart from another two first protruded spacers SPC with four second-second colour pixels PX2g interposed between the two first protruded spacers SPC and the another two first protruded spacers SPC and sequentially arranged in the first direction DR1. In addition, two first protruded spacers SPC may be spaced apart from another two first protruded spacers SPC with four second-second colour pixels PX2g interposed between the two first protruded spacers SPC and the another two first protruded spacers SPC and sequentially arranged in the second direction DR2. However, the arrangement of the first protruded spacers SPC should not be limited thereto or thereby. In an embodiment, two first protruded spacers SPC may be repeatedly arranged with two second-second colour pixels PX2g interposed therebetween. In an alternative embodiment, one of the two first protruded spacers SPC may be omitted.

The second spacer UHSPC may be disposed on the pixel definition pattern PDL1. The second protruded spacer USPC may be disposed on the second spacer UHSPC. In the plan view, the second spacer UHSPC may have a size greater than a size of the second protruded spacer USPC. In the plan view, each of the second spacer UHSPC and the second protruded spacer USPC may be disposed in an area between the first-first light-emitting area PXAir and the first-second light-emitting area PXA1g, an area between the first-first light-emitting area PXA1r and the first-third light-emitting area PXA1b, and an area between the first-second light-emitting area PXA1g and the first-third light-emitting area PXA1b.

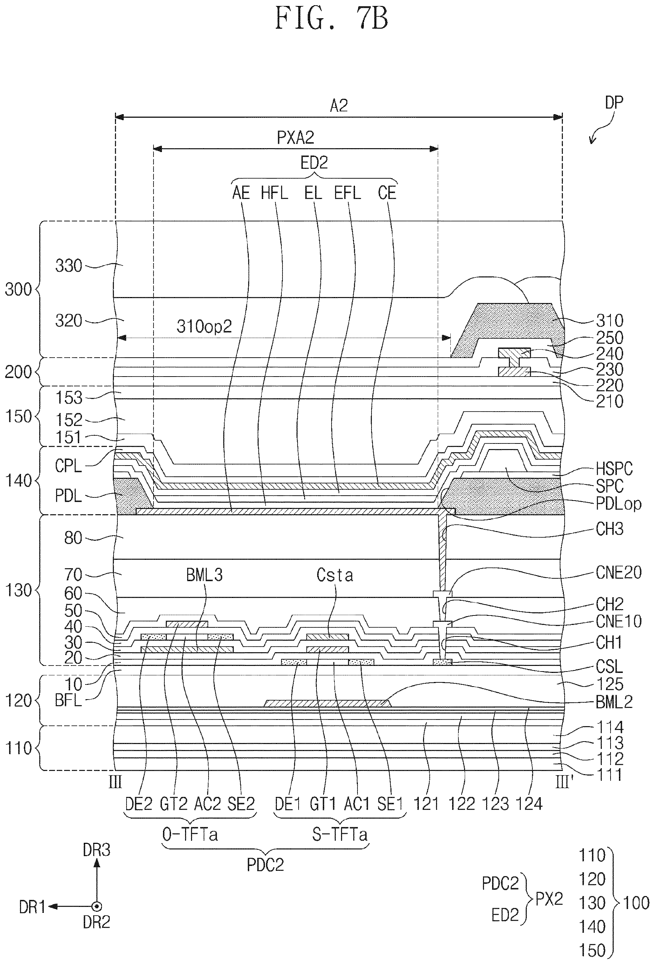

FIG. 7A is a cross-sectional view of an embodiment of the first area A1 of the display panel DP according to the disclosure. FIG. 7B is a cross-sectional view of an embodiment of the second area A2 of the display panel DP according to the disclosure. FIG. 7A is a cross-sectional view taken along line II-II' of FIG. 6, and FIG. 7B is a cross-sectional view taken along line III-III' of FIG. 6.

Referring to FIGS. 7A and 7B, the display panel DP may include the display layer 100, the sensor layer 200, and an anti-reflective layer 300. The display layer 100 may include a base layer 110, a barrier layer 120, a circuit layer 130, an element layer 140, and an encapsulation layer 150.

The base layer 110 may include first, second, third, and fourth sub-base layers 111, 112, 113, and 114.

Each of the first sub-base layer 111 and the fourth sub-base layer 114 may include at least one of a polyimide-based resin, an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "A-based resin" means that a functional group of "A" is included. In an embodiment, each of the first and fourth sub-base layers 111 and 114 may include polyimide.

Each of the second sub-base layer 112 and the third sub-base layer 113 may include an inorganic material. In an embodiment, each of the second sub-base layer 112 and the third sub-base layer 113 may include at least one of silicon oxide, silicon nitride, silicon oxynitride, and amorphous silicon. In an embodiment, the second sub-base layer 112 may include silicon oxynitride, and the third sub-base layer 113 may include silicon oxide.

The first sub-base layer 111 may have a thickness greater than a thickness of the fourth sub-base layer 114. In an embodiment, the thickness of the first sub-base layer 111 may be about 100,000 angstroms, and the thickness of the fourth sub-base layer 114 may be about 56,000 angstroms. The second sub-base layer 112 may have a thickness smaller than a thickness of the third sub-base layer 113. In an embodiment, the thickness of the second sub-base layer 112 may be about 1,000 angstroms, and the thickness of the third sub-base layer 113 may be about 5,000 angstroms. However, the thickness of each of the first, second, third, and fourth sub-base layers 111, 112, 113, and 114 should not be limited thereto or thereby.

The barrier layer 120 may be disposed on the base layer 110. The barrier layer 120 may include a plurality of sub-barrier layers 121, 122, 123, 124, and 125, a first lower light-blocking layer BML1, and a second lower light-blocking layer BML2.

The first and second lower light-blocking layers BML1 and BML2 may be also referred to as first and second lower layers, first and second lower metal layers, first and second lower electrode layers, first and second lower shielding layers, first and second light-blocking layers, first and second metal layers, first and second electrode layers, first and second shielding layers, or first and second overlap layers.

The sub-barrier layers 121, 122, 123, 124, and 125 may include a first sub-barrier layer 121, a second sub-barrier layer 122, a third sub-barrier layer 123, a fourth sub-barrier layer 124, and a fifth sub-barrier layer 125, which are sequentially stacked in a direction away from the base layer 110. Each of the first, second, third, fourth, and fifth sub-barrier layers 121, 122, 123, 124, and 125 may include an inorganic material. In an embodiment, each of the first, second, third, fourth, and fifth sub-barrier layers 121, 122, 123, 124, and 125 may include at least one of silicon oxide, silicon nitride, silicon oxynitride, and amorphous silicon. In an embodiment, the first sub-barrier layer 121 may include silicon oxynitride, the second sub-barrier layer 122 may include silicon oxide, the third sub-barrier layer 123 may include amorphous silicon, the fourth sub-barrier layer 124 may include silicon oxide, and the fifth sub-barrier layer 125 may include silicon oxide.

Among the first, second, third, fourth, and fifth sub-barrier layers 121, 122, 123, 124, and 125, the fifth sub-barrier layer 125 may be disposed closest to the circuit layer 130. The fifth sub-barrier layer 125 may be also referred to as an upper sub-barrier layer. The fifth sub-barrier layer 125 may have a thickness STK1 greater than a thickness of each of the first, second, third, and fourth sub-barrier layers 121, 122, 123, and 124. In an embodiment, the thickness STK1 of the fifth sub-barrier layer 125 may be greater than a sum of thicknesses STK2 of the first, second, third, and fourth sub-barrier layers 121, 122, 123, and 124. In an embodiment, the first sub-barrier layer 121 may have the thickness of about 1,000 angstroms, the second sub-barrier layer 122 may have the thickness of about 1,500 angstroms, the third sub-barrier layer 123 may have the thickness of about 100 angstroms, the fourth sub-barrier layer 124 may have the thickness of about 130 angstroms, and the fifth sub-barrier layer 125 may have the thickness of about 4,200 angstroms. In particular, the thickness STK1 of the fifth sub-barrier layer 125 may be greater than the above-described thickness.

The first lower light-blocking layer BML1 may be disposed in the first area A1 and a portion of the boundary area AM, and the second lower light-blocking layer BML2 may be disposed in the second area A2. The first lower light-blocking layer BML1 and the second lower light-blocking layer BML2 may be electrically insulated from each other, and different signals from each other may be applied to the first lower light-blocking layer BML1 and the second lower light-blocking layer BML2, respectively. In an embodiment, a constant voltage with a predetermined voltage level may be applied to the first lower light-blocking layer BML1, and the first driving voltage ELVDD (refer to FIG. 5) provided to the pixel circuit PDC (refer to FIG. 5) may be applied to the second lower light-blocking layer BML2.

The first lower light-blocking layer BML1 and the second lower light-blocking layer BML2 may be disposed in the same layer and may include the same material. In an embodiment, the first lower light-blocking layer BML1 and the second lower light-blocking layer BML2 may be disposed between the fourth sub-barrier layer 124 and the fifth sub-barrier layer 125. The first lower light-blocking layer BML1 and the second lower light-blocking layer BML2 may be covered by the fifth sub-barrier layer 125. Since the fifth sub-barrier layer 125 has the greatest thickness among the first, second, third, fourth, and fifth sub-barrier layers 121, 122, 123, 124, and 125, the degree of change in characteristics of transistors, which is caused by voltages provided to the first and second lower light-blocking layers BML1 and BML2, may be reduced.

A first opening BMop that defines the transmission area TP may be defined in the first lower light-blocking layer BML1. The first lower light-blocking layer BML1 may be a pattern that serves as a mask when an electrode opening CEop is formed through a common electrode CE. In an embodiment, a light irradiated to the common electrode CE from a rear surface of the base layer 110 may reach a portion of each of the common electrode CE and a capping layer CPL after passing through the first opening BMop of the first lower light-blocking layer BML1. That is, the portion of each of the common electrode CE and the capping layer CPL may be removed by the light passing through the first opening BMop of the first lower light-blocking layer BML1. The light may be a laser beam.

In the first area A1, a portion overlapping the first opening BMop of the first lower light-blocking layer BML1 may be defined as the transmission area TP, and the other portion may be defined as the element area EP. The first pixels PX1r, PX1g, and PX1b (refer to FIG. 6) may be disposed in the element area EP, and the first pixels PX1r, PX1g, and PX1b may be spaced apart from the transmission area TP.

A buffer layer BFL may be disposed on the barrier layer 120. The buffer layer BFL may be disposed in both the first area A1 and the second area A2. The buffer layer BFL may prevent metal atoms or impurities from being diffused to a first semiconductor pattern from the base layer 110. In addition, the buffer layer BFL may control a rate of heat supply during a crystallization process to form the first semiconductor pattern so that the first semiconductor pattern may be uniformly formed.

The buffer layer BFL may include a plurality of inorganic layers. In an embodiment, the buffer layer BFL may include a first sub-buffer layer including or consisting of silicon nitride and a second sub-buffer layer disposed on the first sub-buffer layer and including or consisting of silicon oxide. The buffer layer BFL may not overlap a portion of the transmission area TP. That is, an opening may be defined through the buffer layer BFL to correspond to the transmission area TP. As the buffer layer BFL is not disposed in the transmission area TP, the transmittance of the transmission area TP may be more improved.

FIGS. 7A and 7B show a first pixel PX1 disposed in the first area A1 and a second pixel PX2 disposed in the second area A2. The first pixel PX1 may be one of the first pixels PX1r, PX1g, and PX1b (refer to FIG. 6), and the second pixel PX2 may be one of the second pixels PX2r, PX2g, and PX2b (refer to FIG. 6).

The first pixel PX1 may include a first light-emitting element ED1 and a first pixel circuit PDC1. The second pixel PX2 may include a second light-emitting element ED2 and a second pixel circuit PDC2.

The circuit layer 130 may be disposed on the buffer layer BFL, and the element layer 140 may be disposed on the circuit layer 130. FIG. 7A is a cross-sectional view of a portion of the first light-emitting element ED1 and a portion of the first pixel circuit PDC1, which are disposed in the first area A1, and FIG. 7B is a cross-sectional view of a portion of the second light-emitting element ED2 and a portion of the second pixel circuit PDC2, which are disposed in the second area A2.

Referring to FIG. 7A, a silicon thin film transistor S-TFT and an oxide thin film transistor O-TFT of the first pixel circuit PDC1 are shown as an illustrative embodiment. The silicon thin film transistor S-TFT may be one of the first, second, fifth, sixth, and seventh transistors T1, T2, T5, T6, and T7 described with reference to FIG. 5, and the oxide thin film transistor O-TFT may be one of the third and fourth transistors T3 and T4 described with reference to FIG. 5.

The first, second, third, fourth, fifth, sixth, and seventh transistors T1, T2, T3, T4, T5, T6, and T7 included in the first pixel circuit PDC1 may be also referred to as first-type transistors. In the first area A1, the first lower light-blocking layer BML1 may overlap all the first-type transistors. That is, the first lower light-blocking layer BML1 may completely overlap an area in which the first pixel circuit PDC1 is disposed. Accordingly, a voltage applied to the first lower light-blocking layer BML1 may be provided regardless of an operation of the first pixel circuit PDC1.

Referring to FIG. 7B, a silicon thin film transistor S-TFTa and an oxide thin film transistor O-TFTa of the second pixel circuit PDC2 are shown as an illustrative embodiment. The silicon thin film transistor S-TFTa may be the first transistor T1 described with reference to FIG. 5, and the oxide thin film transistor O-TFTa may be one of the third and fourth transistors T3 and T4 described with reference to FIG. 5. The first, second, third, fourth, fifth, sixth, and seventh transistors T1, T2, T3, T4, T5, T6, and T7 included in the second pixel circuit PDC2 may be also referred to as second-type transistors. In the second area A2, the second lower light-blocking layer BML2 may overlap some of the second-type transistors and may not overlap the other of the second-type transistors. In an embodiment, the second lower light-blocking layer BML2 may overlap a portion of an area in which the second pixel circuit PDC2 is disposed, and particularly, may overlap the first transistor (also referred to as a first driving transistor) T1. Accordingly, a voltage provided to the second lower light-blocking layer BML2 may be provided in synchronization with an operation of the second pixel circuit PDC2.

Referring to FIGS. 7A and 7B, the first semiconductor pattern may be disposed on the buffer layer BFL. The first semiconductor pattern may include a silicon semiconductor. In an embodiment, the silicon semiconductor may include amorphous silicon or polycrystalline silicon. In an embodiment, the first semiconductor pattern may include substantially low temperature polycrystalline silicon, for example.

FIGS. 7A and 7B show only a portion of the first semiconductor pattern disposed on the buffer layer BFL, and the first semiconductor pattern may be further disposed in other areas. The first semiconductor pattern may be arranged with a predetermined rule over the pixels. The first semiconductor pattern may have different electrical properties depending on whether it is doped or not or whether it is doped with an N-type dopant or a P-type dopant. The first semiconductor pattern may include a first region having a relatively substantially high conductivity and a second region having a relatively substantially low conductivity. The first region may be doped with the N-type dopant or the P-type dopant. A P-type transistor may include a doped region doped with the P-type dopant, and an N-type transistor may include a doped region doped with the N-type dopant. The second region may be a non-doped region or a region doped at a concentration lower than that of the first region.

The first region may have a conductivity greater than that of the second region and may substantially serve as an electrode or a signal line. The second region may substantially correspond to an active area (or a channel) of the transistor. In other words, a portion of the first semiconductor pattern may be the active area of the transistor, another portion of the first semiconductor pattern may be a source area or a drain area of the transistor, and the other portion of the first semiconductor pattern may be a connection electrode or a connection signal line.

A source area SE1, an active area AC1, and a drain area DE1 of the silicon thin film transistor S-TFT or S-TFTa may be formed from the first semiconductor pattern. The source area SE1 and the drain area DE1 may extend in opposite directions to each other from the active area AC1 in a cross-section. In an alternative embodiment, a source area and a drain area of a transistor may be switched with each other based on a type of the transistor.

FIG. 7B shows a portion of a connection signal line CSL including or consisting of the first semiconductor pattern. The connection signal line CSL may be electrically connected to the second electrode of the sixth transistor T6 (refer to FIG. 5) and the second electrode the seventh transistor T7 (refer to Fig. 5).

The circuit layer 130 may include a plurality of inorganic layers and a plurality of organic layers. In an embodiment, first, second, third, fourth, and fifth insulating layers 10, 20, 30, 40, and 50 sequentially stacked on the buffer layer BFL may be inorganic layers, and sixth, seventh, and eighth insulating layers 60, 70, and 80 sequentially stacked above the buffer layer BFL may be organic layers.

The first insulating layer 10 may be disposed on the buffer layer BFL. The first insulating layer 10 may cover the first semiconductor pattern. The first insulating layer 10 may be an inorganic layer and may have a single-layer or multi-layer structure. The first insulating layer 10 may include at least one of aluminum oxide, titanium oxide, silicon oxide, silicon nitride, silicon oxynitride, zirconium oxide, and hafnium oxide. In the illustrated embodiment, the first insulating layer 10 may have a single-layer structure of a silicon oxide layer. Not only the first insulating layer 10, but also other insulating layers of the circuit layer 130 described later may have a single-layer or multi-layer structure.

A gate electrode GT1 of the silicon thin film transistor S-TFT or S-TFTa may be disposed on the first insulating layer 10. The gate electrode GT1 may be a portion of a metal pattern. The gate electrode GT1 may overlap the active area AC1. The gate electrode GT1 may be used as a mask in a process of doping the first semiconductor pattern. The gate electrode GT1 may include titanium (Ti), silver (Ag), an alloy including or consisting of silver (Ag), molybdenum (Mo), an alloy including or consisting of molybdenum (Mo), aluminum (Al), an alloy including or consisting of aluminum (Al), aluminum nitride (AlN), tungsten (W), tungsten nitride (WN), copper (Cu), indium tin oxide ("ITO"), indium zinc oxide ("IZO"), or the like, however, it should not be particularly limited.

The second insulating layer 20 may be disposed on the first insulating layer 10 and may cover the gate electrode GT1. The second insulating layer 20 may be an inorganic layer and may have a single-layer or multi-layer structure. The second insulating layer 20 may include at least one of silicon oxide, silicon nitride, and silicon oxynitride. In the illustrated embodiment, the second insulating layer 20 may have a single-layer structure of a silicon nitride layer.

The third insulating layer 30 may be disposed on the second insulating layer 20. The third insulating layer 30 may be an inorganic layer and may have a single-layer or multi-layer structure. In an embodiment, the third insulating layer 30 may have the multi-layer structure of a silicon oxide layer and a silicon nitride layer. One electrode Csta of the first capacitor Cst (refer to FIG. 5) may be disposed between the second insulating layer 20 and the third insulating layer 30. In addition, the other electrode of the first capacitor Cst may be disposed between the first insulating layer 10 and the second insulating layer 20.

A second semiconductor pattern may be disposed on the third insulating layer 30. The second semiconductor pattern may include an oxide semiconductor. The oxide semiconductor may include a plurality of areas distinguished from each other depending on whether a metal oxide is reduced. The area (hereinafter, also referred to as a reduced area) in which the metal oxide is reduced has a conductivity greater than that of the area (hereinafter, also referred to as a non-reduced area) in which the metal oxide is not reduced. The reduced area may act as the source/drain area of the transistor or the signal line. The non-reduced area may substantially correspond to the active area (or a semiconductor area, or a channel) of the transistor. In other words, a portion of the second semiconductor pattern may be the active area of the transistor, another portion of the second semiconductor pattern may be the source/drain areas of the transistor, and the other portion of the second semiconductor pattern may be a signal transmission area.

A source area SE2, an active area AC2, and a drain area DE2 of the oxide thin film transistor O-TFT or O-TFTa may be formed from the second semiconductor pattern. The source area SE2 and the drain area DE2 may extend in opposite directions to each other from the active area AC2 in a cross-section.

The oxide thin film transistor O-TFT disposed in the first area A1 may overlap the first lower light-blocking layer BML1. Accordingly, a light incident into the first area A1 of the display panel DP from a lower side of the display panel DP may be blocked by the first lower light-blocking layer BML1, and thus, may not be provided to the active area AC2 of the oxide thin film transistor O-TFT.

The oxide thin film transistor O-TFTa disposed in the second area A2 may not overlap the second lower light-blocking layer BML2. Accordingly, a layer to block a light traveling toward a lower portion of the oxide thin film transistors O-TFTa may be further provided. In an embodiment, a third lower light-blocking layer BML3 may be disposed under the oxide thin film transistor O-TFTa disposed in the second area A2. The third lower light-blocking layer BML3 may be disposed between the second insulating layer 20 and the third insulating layer 30. The third lower light-blocking layer BML3 may include the same material as that of the one electrode Csta of the first capacitor Cst (refer to FIG. 5) and may be formed through the same process as that of the one electrode Csta of the first capacitor Cst (refer to FIG. 5).

The fourth insulating layer 40 may be disposed on the third insulating layer 30. The fourth insulating layer 40 may cover the second semiconductor pattern. The fourth insulating layer 40 may be an inorganic layer and may have a single-layer or multi-layer structure. The fourth insulating layer 40 may include at least one of aluminum oxide, titanium oxide, silicon oxide, silicon nitride, silicon oxynitride, zirconium oxide, and hafnium oxide. In the illustrated embodiment, the fourth insulating layer 40 may have a single-layer structure of a silicon oxide layer.

A gate electrode GT2 of the oxide thin film transistor O-TFT or O-TFTa may be disposed on the fourth insulating layer 40. The gate electrode GT2 may be a portion of a metal pattern. The gate electrode GT2 may overlap the active area AC2. The gate electrode GT2 may be used as a mask in a process of reducing the second semiconductor pattern.

The fifth insulating layer 50 may be disposed on the fourth insulating layer 40 and may cover the gate electrode GT2. The fifth insulating layer 50 may be an inorganic layer and may have a single-layer or multi-layer structure. In an embodiment, the fifth insulating layer 50 may have a multi-layer structure of a silicon oxide layer and a silicon nitride layer.

A first connection electrode CNE10 may be disposed on the fifth insulating layer 50. The first connection electrode CNE10 may be connected to the connection signal line CSL via a first contact hole CH1 defined through the first to fifth insulating layers 10 to 50.

A second opening ILop may be defined through the buffer layer BFL and at least some insulating layers of the insulating layers 10, 20, 30, 40, 50, 60, 70, and 80, which are included in the circuit layer 130. In an embodiment, the second opening ILop may be defined through the buffer layer BFL and the first, second, third, fourth, and fifth insulating layers 10, 20, 30, 40, and 50. The second opening ILop may be defined in an area overlapping the transmission area TP. That is, as the portion of the buffer layer BFL and the portion of each of the first, second, third, fourth, and fifth insulating layers 10, 20, 30, 40, and 50, which overlap the transmission area TP, are removed, the transmittance of the transmission area TP may be improved.

A minimum width of the second opening ILop may be smaller than a minimum width of the first opening BMop. A sidewall of the buffer layer BFL and the first, second, third, fourth, and fifth insulating layers 10, 20, 30, 40, and 50, which define the second opening ILop, may more protrude than a sidewall of the first lower light-blocking layer BML1 toward the transmission area TP.

The sixth insulating layer 60 may be disposed on the fifth insulating layer 50. The sixth insulating layer 60 may include an organic material. In an embodiment, the sixth insulating layer 60 may include a polyimide-based resin, for example. In an embodiment, the sixth insulating layer 60 may include a photosensitive polyimide. A second connection electrode CNE20 may be disposed on the sixth insulating layer 60. The second connection electrode CNE20 may be connected to the first connection electrode CNE10 via a second contact hole CH2 defined through the sixth insulating layer 60.

The sixth insulating layer 60 may be disposed in both the element area EP and the transmission area TP. The sixth insulating layer 60 may be also referred to as a common organic layer. The sixth insulating layer 60 may be filled in the second opening ILop. That is, the sixth insulating layer 60 may overlap the transmission area TP. As the sixth insulating layer 60 is provided in the transmission area TP, a step difference of the upper surface of the sixth insulating layer 60 may be reduced. When the step differences of the layers overlapping the transmission area TP are reduced, a diffraction of the light incident into the transmission area TP may be alleviated (or reduced). Accordingly, a deformation of the image, which is caused by the diffraction, may be reduced, and the quality of the image acquired by the camera module CMM (refer to FIG. 2A) may be improved.

A portion in the thickness direction of a preliminary common organic layer 60-P disposed in the transmission area TP may be removed to form (or to provide) the sixth insulating layer 60. In FIG. 7A, the preliminary common organic layer 60- P is indicated by a dotted line, and the removed portion 60-del of the preliminary common organic layer 60-P is hatched. A halftone mask may be used to form the sixth insulating layer 60 from the preliminary common organic layer 60- P.

A first thickness TK1 of the sixth insulating layer 60 in the transmission area TP may be smaller than a second thickness TK2 of the sixth insulating layer 60 in the element area EP. In an embodiment, the first thickness TK1 may be a minimum thickness or an average thickness of the sixth insulating layer 60 in the transmission area TP, and the second thickness TK2 may be a maximum thickness or an average thickness of the sixth insulating layer 60 in the element area EP. The first thickness TK1 may be equal to or greater than about 40% and smaller than about 100% of the second thickness TK2. As a difference between the first thickness TK1 and the second thickness TK2 increases, the step difference of the upper surface of the sixth insulating layer 60 may increase. In this case, in a process of patterning a conductive layer closest to the transmission area TP, the conductive layer may be patterned (or removed) more than originally designed. That is, a probability that a line or wiring becomes thinner increases, and accordingly, a probability of occurrence of defects may also increase. In the case where the first thickness TK1 is provided to be about 40% or more of the second thickness TK2 as in the disclosure, the probability of occurrence of defects may decrease. Accordingly, as the first thickness TK1 is provided to be about 40% or more of the second thickness TK2, the transmittance of the transmission area TP may be improved, and defects may be reduced.

In an embodiment, when the second thickness TK2 is about 15,000 angstroms, the first thickness TK1 may be equal to or greater than about 6,000 angstroms and may be equal to or smaller than about, 10,000 angstroms. When the first thickness TK1 is greater than about 10,000 angstroms, the effect of improving the transmittance may be lowered. Accordingly, the first thickness TK1 may be determined in a range equal to or greater than about 40% of the second thickness TK2 and equal to or smaller than about 10,000 angstroms.

The seventh insulating layer 70 may be disposed on the sixth insulating layer 60 and may cover the second connection electrode CNE20. The eighth insulating layer 80 may be disposed on the seventh insulating layer 70.

Each of the sixth insulating layer 60, the seventh insulating layer 70, and the eighth insulating layer 80 may be an organic layer. In the disclosure, the sixth insulating layer 60 may be also referred to as a first organic insulating layer, the seventh insulating layer 70 may be also referred to as a second organic insulating layer, and the eighth insulating layer 80 may be also referred to as a third organic insulating layer. In an embodiment, each of the sixth insulating layer 60, the seventh insulating layer 70, and the eighth insulating layer 80 may include a general-purpose polymer, such as benzocyclobutene ("BCB"), polyimide, hexamethyldisiloxane ("HMDSO"), polymethylmethacrylate ("PMMA"), or polystyrene ("PS"), a polymer derivative having a phenolic group, an acrylic-based polymer, an imide-based polymer, an aryl ether-based polymer, an amide-based polymer, a fluorine-based polymer, a p-xylene-based polymer, a vinyl alcohol-based polymer, or blends thereof.

Referring to FIGS. 7A and 7B, the element layer 140 including the first and second light-emitting elements ED1 and ED2 may be disposed on the circuit layer 130. Each of the first and second light-emitting elements ED1 and ED2 may include a pixel electrode AE (or an anode), a first functional layer HFL, a light-emitting layer EL, a second functional layer EFL, and a common electrode CE (or a cathode). The first functional layer HFL, the second functional layer EFL, and the common electrode CE may be commonly provided over the pixels PX (refer to FIG. 4).

The pixel electrode AE may be disposed on the eighth insulating layer 80. The pixel electrode AE may be connected to the second connection electrode CNE20 via a third contact hole CH3 defined through the seventh and eighth insulating layers 70 and 80. The pixel electrode AE may be a semi-transmissive electrode, a transmissive electrode, or a reflective electrode. In an embodiment, the pixel electrode AE may include a reflective layer including or consisting of Ag, Mg, Al, Pt, Pd, Au, Ni, Nd, Ir, Cr, or compounds thereof and a transparent or semi-transparent electrode layer formed on the reflective layer. The transparent or semi-transparent electrode layer may include at least one of ITO, IZO, indium gallium zinc oxide ("IGZO"), zinc oxide (ZnO), indium oxide (In2O3), and aluminum-doped zinc oxide ("AZO"). In an embodiment, the pixel electrode AE may have a stack structure of ITO/Ag/ITO, for example.

The pixel definition layer PDL may be disposed on the eighth insulating layer 80. The pixel definition layer PDL may have a light absorbing property, e.g., the pixel definition layer PDL may have a black colour. The pixel definition layer PDL may include a black colouring agent. The black colouring agent may include a black dye or a black pigment. The black colouring agent may include carbon black, a metal material, such as chromium, or an oxide thereof.

A pixel definition opening PDLop may be defined through the pixel definition layer PDL to expose a portion of the pixel electrode AE. That is, the pixel definition layer PDL may cover an edge of the pixel electrode AE. In addition, the pixel definition layer PDL may cover a side surface of the eighth insulating layer 80 adjacent to the transmission area TP. The pixel definition layer PDL may be spaced apart from a side surface of the seventh insulating layer 70 adjacent to the transmission area TP. Accordingly, the pixel definition layer PDL may be stably in contact with the seventh insulating layer 70 and the eighth insulating layer 80. In an embodiment, an opening 700p overlapping the transmission area TP may be defined in the seventh insulating layer 70.

The light-emitting areas may be defined by the pixel definition openings PDLop defined through the pixel definition layer PDL. In an embodiment, a first light-emitting area PXA1 may be defined in the first light-emitting element ED1, and a second light-emitting area PXA2 may be defined in the second light-emitting element ED2.

The first spacer HSPC may be disposed on the pixel definition film PDL2 (refer to FIG. 6). The first protruded spacer SPC may be disposed on the first spacer HSPC. The first spacer HSPC and the first protruded spacer SPC may be provided unitarily with each other and may include or consist of the same material. In an embodiment, the first spacer HSPC and the first protruded spacer SPC may be formed through the same process using the halftone mask, however, this is merely one of embodiments. In an embodiment, the first spacer HSPC and the first protruded spacer SPC may include different materials from each other and may be formed through different processes from each other.

The second spacer UHSPC described with reference to FIG. 6 may have substantially the same thickness as that of the first spacer HSPC, and the second protruded spacer USPC may have substantially the same thickness as that of the first protruded spacer SPC. In addition, the second spacer UHSPC and the second protruded spacer USPC may have shapes similar to those of the first spacer HSPC and the first protruded spacer SPC shown in FIG. 7B in a cross-section.

The first functional layer HFL may be disposed on the pixel electrode AE, the pixel definition layer PDL, the first spacer HSPC, and the first protruded spacer SPC. The first functional layer HFL may include a hole transport layer, may include a hole injection layer, or may include both the hole transport layer and the hole injection layer. The first functional layer HFL may be disposed in the first area A1, the second area A2, and the boundary area AM (refer to FIG. 6).

The light-emitting layer EL may be disposed on the first functional layer HFL and may be disposed in an area corresponding to the pixel definition opening PDLop of the pixel definition layer PDL. The light-emitting layer EL may include an organic material, an inorganic material, or an organic-inorganic material, which emits a light having a predetermined colour. The light-emitting layer EL may be disposed in the first area A1, the second area A2, and the boundary area AM. The light-emitting layer EL disposed in the first area A1 may be disposed in an area spaced apart from the transmission area TP, i.e., the element area EP.

The second functional layer EFL may be disposed on the first functional layer HFL and may cover the light-emitting layer EL. The second functional layer EFL may include an electron transport layer, may include an electron injection layer, or may include both the electron transport layer and the electron injection layer. The second functional layer EFL may be disposed in the first area A1, the second area A2, and the boundary area AM.

The common electrode CE maybe disposed on the second functional layer EFL. The common electrode CE may be disposed in the first area A1, the second area A2, and the boundary area AM. An electrode opening CEop may be defined through the common electrode CE to overlap the first opening BMop. A minimum width of the electrode opening CEop may be greater than a minimum width of the first opening BMop of the first lower light-blocking layer BML1.

The element layer 140 may further include the capping layer CPL disposed on the common electrode CE. The capping layer CPL may improve a light emission efficiency by the principle of constructive interference. The capping layer CPL may include a material having a refractive index equal to or greater than about 1.6 with respect to a light with a wavelength of about 589 nanometer (nm). The capping layer CPL may be an organic capping layer including an organic material, an inorganic capping layer including an inorganic material, or a composite capping layer including the organic material and the inorganic material. In an embodiment, the capping layer CPL may include carbocyclic compounds, heterocyclic compounds, amine group-containing compounds, porphine derivatives, phthalocyanine derivatives, naphthalocyanine derivatives, alkali metal complexes, alkaline earth metal complexes, or any combinations thereof, for example. The carbocyclic compounds, the heterocyclic compounds, and the amine group-containing compounds may optionally be substituted with substituents including O, N, S, Se, Si, F, Cl, Br, I, or any combinations thereof.

A portion of the capping layer CPL, which overlaps the electrode opening CEop of the common electrode CE, may be removed. As the portion of the capping layer CPL and the portion of the common electrode CE overlapping the transmission area TP, are removed, the transmittance of the transmission area TP may be improved.

The encapsulation layer 150 may be disposed on the element layer 140. The encapsulation layer 150 may include an inorganic layer 151, an organic layer 152, and an inorganic layer 153, which are sequentially stacked, however, layers included in the encapsulation layer 150 should not be limited thereto or thereby.

The inorganic layers 151 and 153 may protect the element layer 140 from moisture and oxygen, and the organic layer 152 may protect the element layer 140 from a foreign substance such as dust particles. The inorganic layers 151 and 153 may include a silicon nitride layer, a silicon oxynitride layer, a silicon oxide layer, a titanium oxide layer, or an aluminum oxide layer. The organic layer 152 may include an acrylic-based organic layer, however, it should not be limited thereto or thereby.

The sensor layer 200 may be disposed on the display layer 100. The sensor layer 200 may be also referred to as a sensor, an input sensing layer, or an input sensing panel. The sensor layer 200 may include a sensor base layer 210, a first sensor conductive layer 220, a sensor insulating layer 230, a second sensor conductive layer 240, and a sensor cover layer 250.

The sensor base layer 210 may be disposed directly on the display layer 100. The sensor base layer 210 may be an inorganic layer including at least one of silicon nitride, silicon oxynitride, and silicon oxide. In an embodiment, the sensor base layer 210 may be an organic layer including an epoxy-based resin, an acrylic-based resin, or an imide-based resin. The sensor base layer 210 may have a single-layer structure or a multi-layer structure of layers stacked in the third direction DR3.

Each of the first sensor conductive layer 220 and the second sensor conductive layer 240 may have a single-layer structure or a multi-layer structure of layers stacked in the third direction DR3.

The conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as ITO, IZO, zinc oxide (ZnO), indium tin zinc oxide ("ITZO"), or the like. In addition, the transparent conductive layer may include a conductive polymer such as poly(3,4-ethylene dioxythiophene) ("PEDOT"), metal nanowire, graphene, or the like.

The conductive layer having the multi-layer structure may include metal layers. The metal layers may have a three-layer structure of titanium/aluminum/titanium. The conductive layer having the multi-layer structure may include at least one metal layer and at least one transparent conductive layer.

The sensor insulating layer 230 may be disposed between the first sensor conductive layer 220 and the second sensor conductive layer 240. The sensor insulating layer 230 may include an inorganic layer. The inorganic layer may include at least one of aluminum oxide, titanium oxide, silicon oxide, silicon nitride, silicon oxynitride, zirconium oxide, and hafnium oxide.

In an embodiment, the sensor insulating layer 230 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

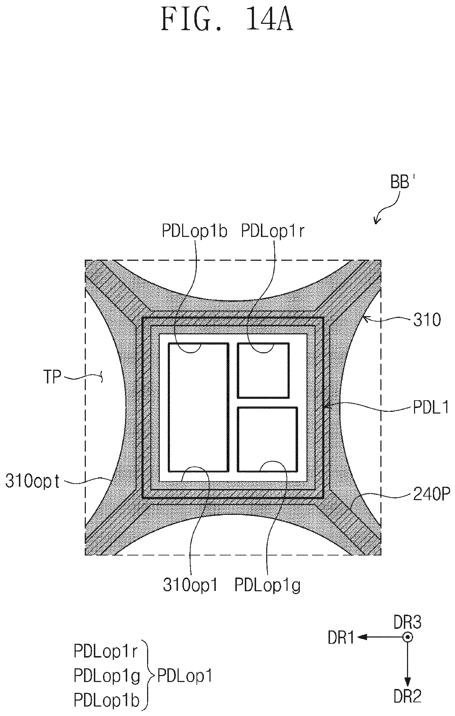

The sensor cover layer 250 may be disposed on the sensor insulating layer 230 and may cover the second sensor conductive layer 240. The second sensor conductive layer 240 may include a conductive pattern 240P (refer to FIG. 14A). The sensor cover layer 250 may cover the conductive pattern 240P and may reduce a possibility of occurrence of damages in the conductive pattern 240P in a subsequent process.

The sensor cover layer 250 may include an inorganic material. In an embodiment, the sensor cover layer 250 may include silicon nitride, however, it should not be limited thereto or thereby.

The anti-reflective layer 300 may be disposed on the sensor layer 200. The anti-reflective layer 300 may include a division layer 310, a plurality of colour filters 320, and a planarization layer 330. The division layer 310 and the colour filters 320 may not be disposed in the transmission area TP of the first area A1. The term "division layer" is alternatively referred to as a "partition layer".

The division layer 310 may be disposed to overlap the conductive pattern 240P (refer to FIG. 14A) of the second sensor conductive layer 240. The sensor cover layer 250 may be disposed between the division layer 310 and the second sensor conductive layer 240. The division layer 310 may prevent an external light from being reflected by the second sensor conductive layer 240. Materials for the division layer 310 should not be particularly limited as long as the materials absorb light. The division layer 310 may have a black colour and may include a black colouring agent. The black colouring agent may include a black dye or a black pigment. The black colouring agent may include carbon black, a metal material, such as chromium, or an oxide thereof.

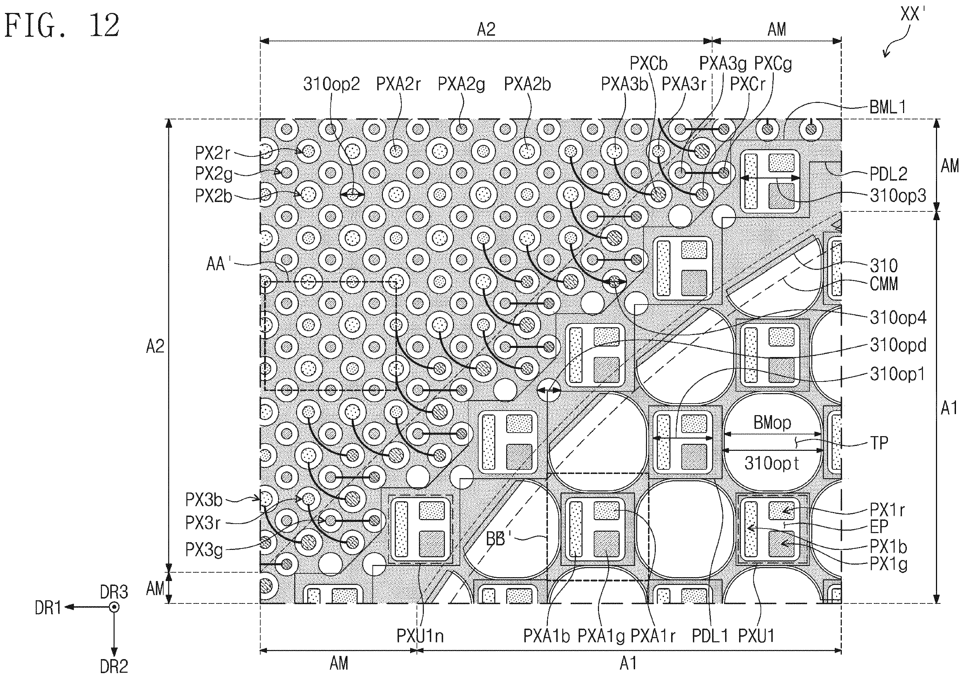

A plurality of openings, which may be referred to as division openings, or partition openings, 310op1 and 310op2 and a transmission opening 310opt may be defined through the division layer 310. The division openings 3100p1 and 310op2 may overlap the light-emitting layers EL. For reference, the shape of the division layer 310 in a plane is as shown in FIG. 12. The colour filters 320 may be disposed to correspond to the division openings 3100p1 and 310op2. The colour filters 320 may transmit a light provided from the light-emitting layer EL overlapping the colour filters 320.

The transmission opening 310opt of the division layer 310 may overlap the first opening BMop of the first lower light-blocking layer BML1. A minimum width of the transmission opening 310opt of the division layer 310 may be substantially the same as a minimum width of the first opening BMop of the first lower light-blocking layer BML1. That is, an edge of the division layer 310 may be substantially aligned with an edge of the first lower light-blocking layer BML1 in an area adjacent to the transmission area TP. In the disclosure, the expression "components are substantially aligned with each other" or the expression "components have substantially the same width as each other" not only means a case that one component is completely aligned with the other component or a case that a width of one component is physically the same as a width of the other component but also means a case that one component coincides with the other component within a range including differences that may occur due to fabrication errors in spite of the same design.

An edge of the division layer 310 may more protrude than an edge of the pixel definition layer PDL and an edge of the common electrode CE in the area adjacent to the transmission area TP.

The planarization layer 330 may cover the division layer 310 and the colour filters 320. The planarization layer 330 may include an organic material and may provide a flat surface on an upper surface thereof. In an embodiment, the planarization layer 330 may be omitted.

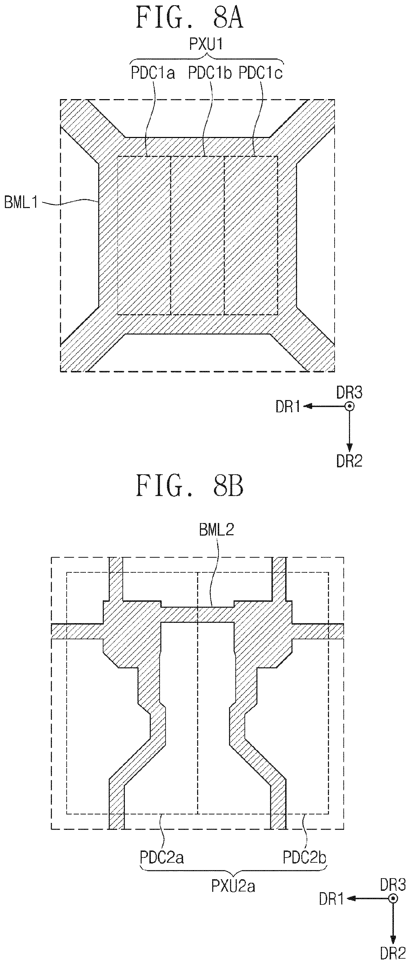

FIG. 8A is a plan view of an embodiment of a portion of the first lower light-blocking layer BML1 according to the disclosure. FIG. 8B is a plan view of an embodiment of a portion of the second lower light-blocking layer BML2 according to the disclosure.

The first pixel unit PXU1 overlapping the first lower light-blocking layer BML1 is indicated by a dotted line in FIG. 8A, and the first sub-pixel unit PXU2a overlapping the second lower light-blocking layer BML2 is indicated by a dotted line in FIG. 8B. An arrangement relationship between the second sub-pixel unit PXU2b (refer to FIG. 6) and the second lower light-blocking layer BML2 may be substantially the same as an arrangement relationship between the first sub-pixel unit PXU2a and the second lower light-blocking layer BML2, and thus, details of the arrangement relationship between the second sub-pixel unit PXU2b (refer to FIG. 6) and the second lower light-blocking layer BML2 will be omitted.

The first pixel unit PXU1 may include three first pixel circuits PDC1a, PDC1b, and PDC1c. The first sub-pixel unit PXU2a may include two second pixel circuits PDC2a and PDC2b. Dotted line regions shown in FIGS. 8A and 8B may respectively correspond to areas in which the three first pixel circuits PDC1a, PDC1b, and PDCic and the two second pixel circuits PDC2a and PDC2b are disposed.

Referring to FIGS. 8A and 8B, the first lower light-blocking layer BML1 and the second lower light-blocking layer BML2 may be disposed in the same layer and may be substantially simultaneously formed through the same process. As a result, when compared with a process of forming the first and second lower light-blocking layers disposed in different layers from each other, in the process of forming the first and second lower light-blocking layers BML1 and BML2 in the illustrated embodiment, a mask process may be omitted one time. Accordingly, a manufacturing process of the display panel DP (refer to FIG. 7A) may be simplified, and a manufacturing cost of the display panel DP may be reduced.

The first lower light-blocking layer BML1 and the second lower light-blocking layer BML2 may be disposed between the fourth sub-barrier layer 124 and the fifth sub-barrier layer 125 shown in FIGS. 7A and 7B.

The first lower light-blocking layer BML1 and the second lower light-blocking layer BML2 may be electrically insulated from each other. The constant voltage with the predetermined voltage level may be provided to the first lower light-blocking layer BML1, and a power voltage applied to the second pixel circuit PDC2a or PDC2b may be provided to the second lower light-blocking layer BML2. In an embodiment, the first driving voltage ELVDD (refer to FIG. 5) may be provided to the second lower light-blocking layer BML2.

The first lower light-blocking layer BML1 may entirely overlap the area in which the first pixel unit PXU1 is disposed. Accordingly, the first lower light-blocking layer BML1 may overlap the first pixels PX1r, PX1g, and PX1b (refer to FIG. 6) included in the first pixel unit PXU1. In the first area A1, the first lower light-blocking layer BML1 may overlap all the first-type transistors included in each of the first pixels PX1r, PX1g, and PX1b. Accordingly, the voltage provided to the first lower light-blocking layer BML1 may be provided regardless of the operation of the first pixels PX1r, PX1g, and PX1b.

The second lower light-blocking layer BML2 may overlap a portion of the area in which the first sub-pixel unit PXU2a is disposed. In an embodiment, the first sub-pixel unit PXU2a may include the second-second colour pixel PX2g (refer to FIG. 6) and the second-third colour pixel PX2b (refer to FIG. 6). In the second area A2, the second lower light-blocking layer BML2 may overlap a portion of the second-type transistors included in each of the second-second colour pixel PX2g and the second-third colour pixel PX2b. In an embodiment, the second lower light-blocking layer BML2 may overlap the first transistor T1 (refer to FIG. 5). Accordingly, the voltage provided to the second lower light-blocking layer BML2 may be provided in synchronization with an operation of the second-second colour pixel PX2g and the second-third colour pixel PX2b.

Each of the first lower light-blocking layer BML1 and the second lower light-blocking layer BML2 may have a single-layer structure or a multi-layer structure of multiple layers. In an embodiment, each of the first lower light-blocking layer BML1 and the second lower light-blocking layer BML2 may have a multi-layer structure in which titanium and molybdenum are sequentially stacked. A passage may be provided by cracks generated in the first, second, third, and fourth sub-barrier layers 121, 122, 123, and 124 (refer to FIG. 7A) and particles between the first, second, third, and fourth sub-barrier layers 121, 122, 123, and 124 (refer to FIG. 7A). In this case, hydrogen may be introduced through the passage, and a lower layer including or consisting of titanium may serve to adsorb hydrogen. Accordingly, an occurrence of defects due to the hydrogen may be reduced in the transistor. In an embodiment, molybdenum may be substituted with copper. In an embodiment, each of the first lower light-blocking layer BML1 and the second lower light-blocking layer BML2 may include molybdenum or copper, however, the disclosure should not be particularly limited.

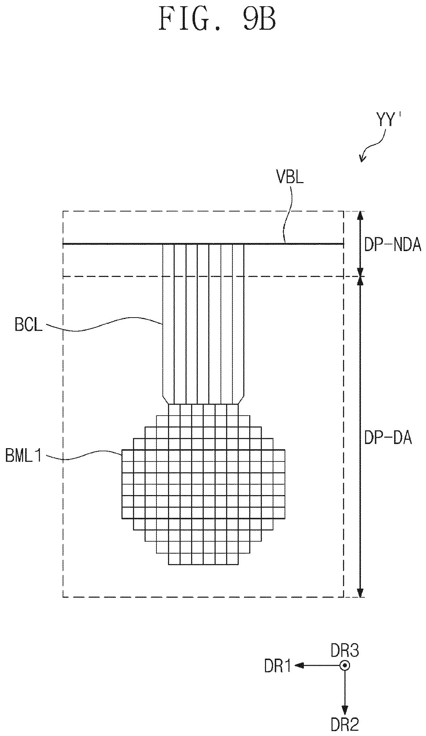

FIG. 9A is an enlarged plan view of an embodiment of a portion of the display panel DP according to the disclosure. FIG. 9B is an enlarged plan view of a portion of the display panel DP according to the disclosure. FIG. 9A is an enlarged plan view of the portion XX' shown in FIG. 4. FIG. 9B is an enlarged plan view of a portion YY' shown in FIG. 4.

Referring to FIGS. 9A and 9B, the first lower light-blocking layer BML1 may be disposed in the first area A1 and a portion of the boundary area AM. In an embodiment, the first lower light-blocking layer BML1 may be disposed in the portion of the boundary area AM to overlap the boundary pixel unit PXU1n.

The display panel DP (refer to FIG. 4) may further include a first light-blocking voltage line VBL and a second light-blocking voltage line BCL. The first light-blocking voltage line VBL and the second light-blocking voltage line BCL may be electrically connected to the first lower light-blocking layer BML1 and may apply the constant voltage with the predetermined voltage level to the first lower light-blocking layer BML1.

In an embodiment, the first light-blocking voltage line VBL may be disposed in the non-display area DP-NDA and may surround at least a portion of the display area DP-DA. Pads PD (refer to FIG. 4) may be respectively connected to opposite ends of the first light-blocking voltage line VBL, and the constant voltage may be respectively provided to the opposite ends of the first light-blocking voltage line VBL via the pads PD.

The second light-blocking voltage line BCL may extend from the first light-blocking voltage line VBL and may be connected to the first lower light-blocking layer BML1 via the display area DP-DA. The second light-blocking voltage line BCL may be provided in plural. FIG. 9B shows eight second light-blocking voltage lines BCL as an illustrative embodiment, however, the number of the second light-blocking voltage lines BCL may be smaller or greater than eight.

FIG. 9A shows the camera module CMM overlapping the first area A1. A dotted line indicated as the camera module CMM may correspond to a light-receiving portion or a lens of the camera module CMM that receives a light.

The camera module CMM may overlap the first area A1. In an embodiment, the camera module CMM may overlap the transmission areas TP and the element areas EP in which the first pixel unit PXU1 is disposed. The camera module CMM may not overlap the boundary area AM and the second area A2. Accordingly, the camera module CMM may not overlap the boundary pixel unit PXU1n, the second pixels PX2r, PX2g, and PX2b and the third pixels PX3r, PX3g, and PX3b.

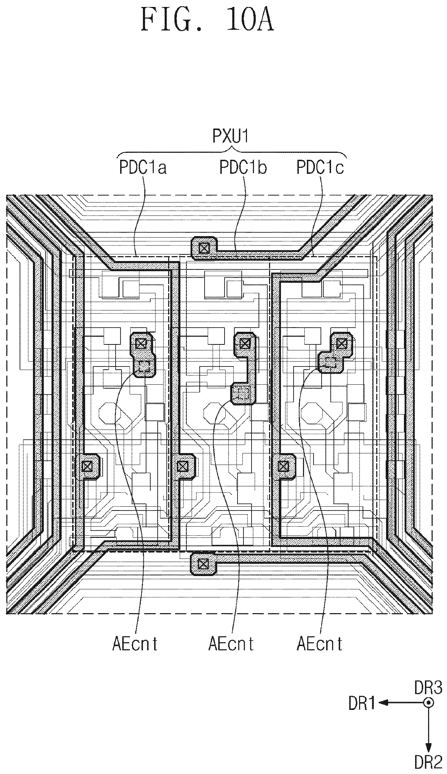

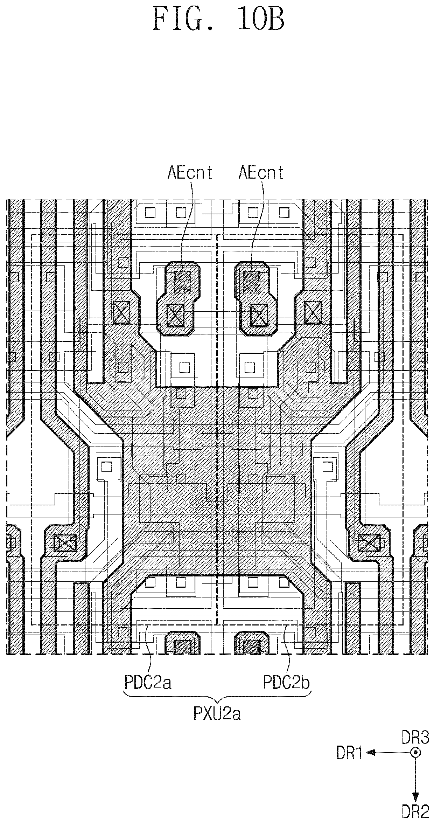

FIG. 10A is a plan view of an embodiment of pixel circuits PDC arranged in the first area A1 according to the disclosure. FIG. 10B is a plan view of an embodiment of pixel circuits PDC arranged in the second area A2 according to the disclosure.

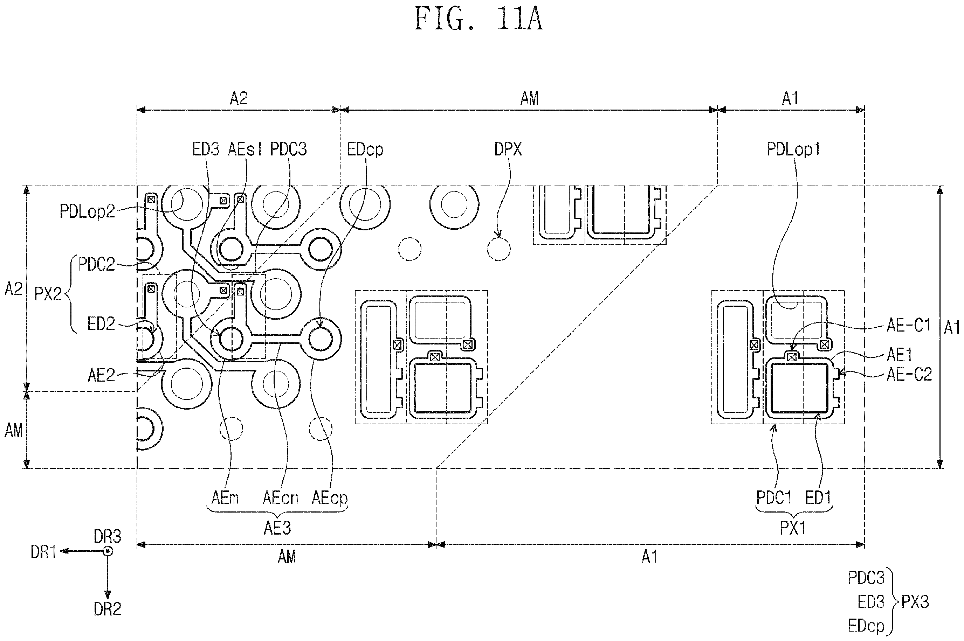

Referring to FIGS. 10A and 10B, each of the first pixel circuits PDC1a, PDC1b, and PDCic and the second pixel circuits PDC2a and PDC2b may be implemented by a plurality of conductive layers and a plurality of semiconductor layers. In FIGS. 10A and 10B, the patterns included in the conductive layer disposed between the sixth insulating layer 60 (refer to FIG. 7B) and the seventh insulating layer 70 (refer to FIG. 7B) are shown in shading. Pixel electrode contact portions AEcnt may contact first, second, and third pixel electrodes AE1, AE2, and AE3 (refer to FIG. 11A) described later.

The third pixel circuit PDC3 (refer to FIG. 11A) having substantially the same layout as that of the second pixel circuit PDC2a or PDC2b may be disposed under the third light-emitting element ED3 (refer to FIG. 11A). A structure such as the second pixel circuit PDC2a or PDC2b may not be disposed in the area where the copy light-emitting element EDcp (refer to FIG. 11A) is arranged due to space constraints. Accordingly, the copy light-emitting element EDcp may share the third pixel circuit PDC3 and may be driven together with the third light-emitting element ED3.

FIG. 11A is an enlarged plan view of an embodiment of a portion of the display panel DP according to the disclosure.

Referring to FIG. 11A, the first pixel electrode AE1 may be disposed in the first area A1, the second pixel electrode AE2 may be disposed in the second area A2, and the third pixel electrode AE3 may be disposed in the boundary area AM or over the second area A2 and the boundary area AM. The first pixel electrode AE1, the second pixel electrode AE2, and the third pixel electrode AE3 may include a metal, an alloy, a conductive metal oxide, a transparent conductive material, or the like. The first pixel electrode AE1, the second pixel electrode AE2, and the third pixel electrode AE3 may have a multi-layer structure in which ITO, silver, and ITO are sequentially stacked, however, they should not be limited thereto or thereby.

The first pixel PX1 disposed in the first area A1 may include the first pixel circuit PDC1 and the first light-emitting element ED1. The first pixel electrode AE1 may be included in the first light-emitting element ED1. The first pixel electrode AE1 may be electrically connected to the first pixel circuit PDC1. In an embodiment, the first pixel electrode AE1 may contact the pixel electrode contact portion AEcnt shown in FIG. 10A.

The second pixel PX2 disposed in the second area A2 may include the second pixel circuit PDC2 and the second light-emitting element ED2. The second pixel electrode AE2 may be included in the second light-emitting element ED2. The second pixel electrode AE2 may be electrically connected to the second pixel circuit PDC2. In an embodiment, the second pixel electrode AE2 may be connected to the pixel electrode contact portion AEcnt shown in FIG. 10B. The third pixel electrode AE3 may be electrically connected to the third pixel circuit PDC3. The third pixel circuit PDC3 may have substantially the same layout as that of one of the second pixel circuits PDC2a and PDC2b shown in FIG. 10B.

The third pixel PX3 disposed in the boundary area AM or over the second area A2 and the boundary area AM may include the third pixel circuit PDC3, the third light-emitting element ED3, and the copy light-emitting element EDcp. The copy light-emitting element EDcp may be disposed closer to the first light-emitting element ED1 than the third light-emitting element ED3. The third pixel circuit may not be disposed under the copy light-emitting element EDcp due to space constraints. Accordingly, the copy light-emitting element EDcp may not overlap the first lower light-blocking layer BML1 (refer to FIG. 8A) and the second lower light-blocking layer BML2 (refer to FIG. 8B).

The third pixel electrode AE3 may be included in the third light-emitting element ED3 and the copy light-emitting element EDcp. The third pixel electrode AE3 may include the main pixel electrode AEm, the connection electrode AEcn, and the copy pixel electrode AEcp. The main pixel electrode AEm may be included in the third light-emitting element ED3, and the copy pixel electrode AEcp may be included in the copy light-emitting element EDcp. The connection electrode AEcn may electrically connect the third light-emitting element ED3 and the copy light-emitting element EDcp.

The main pixel electrode AEm, the connection electrode AEcn, and the copy pixel electrode AEcp may be disposed in the same layer and may include the same material. In addition, the main pixel electrode AEm, the connection electrode AEcn, and the copy pixel electrode AEcp may be substantially simultaneously formed through the same process. The main pixel electrode AEm may be directly connected to the third pixel circuit PDC3, and the copy pixel electrode AEcp may be connected to the third pixel circuit via the connection electrode AEcn and the main pixel electrode AEm.

Some of the main pixel electrodes AEm may include a straight edge AEsl to secure an area through which the connection electrode AEcn passes. The straight edge AEsl may be provided at a portion facing the connection electrode AEcn.

The first pixel electrode AE1 may include a first protruding portion AE-C1 and a second protruding portion AE-C2. The first protruding portion AE-C1 may be connected to the pixel electrode contact portion AEcnt shown in FIG. 10A and may overlap a contact hole. The second protruding portion AE-C2 may be a portion extended to overlap the second semiconductor pattern including the active area AC2 (refer to FIG. 7A) of the oxide thin film transistor O-TFT (refer to FIG. 7A). Accordingly, the light may be blocked by the first lower light-blocking layer BML1 (refer to FIG. 9A) at a lower surface of the second semiconductor pattern, and the light may be blocked by the first pixel electrode AE1 at an upper surface of the second semiconductor pattern.

A dummy pixel DPX may be disposed in the boundary area AM. The dummy pixel DPX may not emit a light and may be also referred to as a defective pixel. In an embodiment, the dummy pixel DPX may not include the pixel circuit PDC (refer to FIG. 5) and the pixel electrode AE (refer to FIG. 7B) and may include the light-emitting layer EL (refer to FIG. 7B). The dummy pixel DPX may further include the first functional layer HFL (refer to FIG. 7B), the second functional layer EFL (refer to FIG. 7B), and the common electrode CE (refer to FIG. 7B). The dummy pixel DPX may overlap a dummy division opening defined through the division layer 310 (refer to FIG. 7B), however, this is merely one of embodiments. In an embodiment, the dummy division opening may not be defined in the area in which the dummy pixel DPX is disposed. In an embodiment, a dummy pixel definition opening may be defined through the pixel definition film PDL2 (refer to FIG. 6) to correspond to the area in which dummy pixel DPX is disposed.

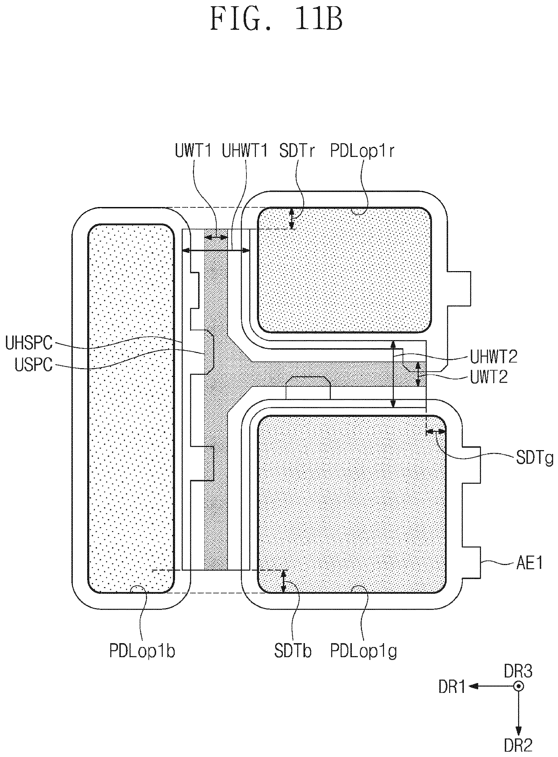

FIG. 11B is a plan view of an embodiment of some components of the display panel DP according to the disclosure.

FIG. 11A shows a second spacer UHSPC, a second protruded spacer USPC, and first pixel electrodes AE1.

The second spacer UHSPC and the second protruded spacer USPC may be disposed on the pixel definition pattern PDL1 (refer to FIG. 6). In the plan view, the second spacer UHSPC and the second protruded spacer USPC may be disposed between a first-first pixel definition opening PDLop1r and a first-second pixel definition opening PDLopig, between the first-first pixel definition opening PDLop1r and a first-third pixel definition opening PDLop1b, and between the first-second pixel definition opening PDLop1g and the first-third pixel definition opening PDLop1b.

A first width UHWT1 in the first direction DR1 of the second spacer UHSPC may be greater than a second width UWT1 in the first direction DR1 of the second protruded spacer USPC, and a third width UHWT2 in the second direction DR2 of the second spacer UHSPC may be greater than a fourth width UWT2 in the second direction DR2 of the second protruded spacer USPC. In an embodiment, each of the first width UHWT1 and the third width UHWT2 may be about 14.8 micrometers, and each of the second width UWT1 and the fourth width UWT2 may be about 5 micrometers, however, they should not be particularly limited.

The second spacer UHSPC and the second protruded spacer USPC may be spaced apart from an outermost line of each of the first-first pixel definition opening PDLop1r, the first-second pixel definition opening PDLopig, and the first-third pixel definition opening PDLop1b. In an embodiment, distances SDTr, SDTg, and SDTb between the second spacer UHSPC or the second protruded spacer USPC and an outermost line of each of the first-first pixel definition opening PDLop1r, the first-second pixel definition opening PDLopig, and the first-third pixel definition opening PDLop1b may be equal to or greater than about 4 micrometers. Accordingly, a portion of the pixel definition pattern PDL1 (refer to FIG. 6) may be exposed in an area adjacent to the transmission area TP (refer to FIG. 7A). Due to the exposed pixel definition pattern PDL1, a step difference in the area adjacent to the transmission area TP may be reduced. As a result, a burr generated in a portion of the common electrode CE (refer to FIG. 7A) may be reduced.

FIG. 12 is an enlarged plan view of an embodiment of a portion of the display panel DP according to the disclosure. FIG. 12 is an enlarged plan view of the portion XX' shown in FIG. 4.

Referring to FIGS. 7A, 7B, and 12, the division openings 3100p1 and 310op2, division openings 310op3 and 310op4, and the transmission opening 310opt may be defined through the division layer 310. The division openings 310op1, 310op2, 310op3, and 310op4 may include a first division opening 3100p1 defined in the first area A1, a second division opening 310op2 defined in the second area A2, a third division opening 310op3 defined in the boundary area AM, and a fourth division opening 310op4 defined in the boundary area AM. The transmission opening 310opt may be defined in the first area A1.

The third division opening 310op3 may have substantially the same shape as that of the first division opening 310op1. The fourth division opening 310op4 may have substantially the same shape as that of the second division opening 310op2.

In the first area A1, one first division opening 3100p1 may overlap one first pixel unit PXU1, and one third division opening 310op3 may overlap one boundary pixel unit PXUin in the boundary area AM. Accordingly, each of the one first division opening 3100p1 and the one third division opening 310op3 may overlap the first light-emitting areas PXA1r, PXA1g, and PXA1b.

The division layer 310 may not be disposed between the first light-emitting areas PXA1r, PXA1g, and PXAib adjacent to each other in the first area A1. Accordingly, there is no need to form a relatively thin and long portion of the division layer 310 in a narrow area between the first light-emitting areas PXA1r, PXA1g and PXA1b. Accordingly, a difficulty of the process of forming the division layer 310 may be reduced. In addition, since the portion of the division layer 310 is not disposed between the first light-emitting areas PXA1r, PXA1g, and PXA1b, a degree of change in luminance ratio or white angular dependency ("WAD") characteristic may be reduced even though the viewing angle increases. That is, the luminance ratio or the WAD characteristic may be improved in the first area A1.

In the second area A2 and the boundary area AM, each of one second division opening 310op2 and one fourth division opening 310op4 may overlap one light-emitting area among the second light-emitting areas PXA2r, PXA2g, and PXA2b, the third light-emitting areas PXA3r, PXA3g, and PXA3b, and the copy light-emitting areas PXCr, PXCg, and PXCb. In the second area A2 and the boundary area AM, a portion of the division layer 310 may be disposed between the second light-emitting areas PXA2r, PXA2g, and PXA2b, the third light-emitting areas PXA3r, PXA3g, and PXA3b, and the copy light-emitting areas PXCr, PXCg, and PXCb adjacent to each other.

The transmission opening 310opt may overlap the first opening BMop of the first lower light-blocking layer BML1. The transmission opening 310opt may have substantially the same size as that of the first opening BMop of the first lower light-blocking layer BML1.

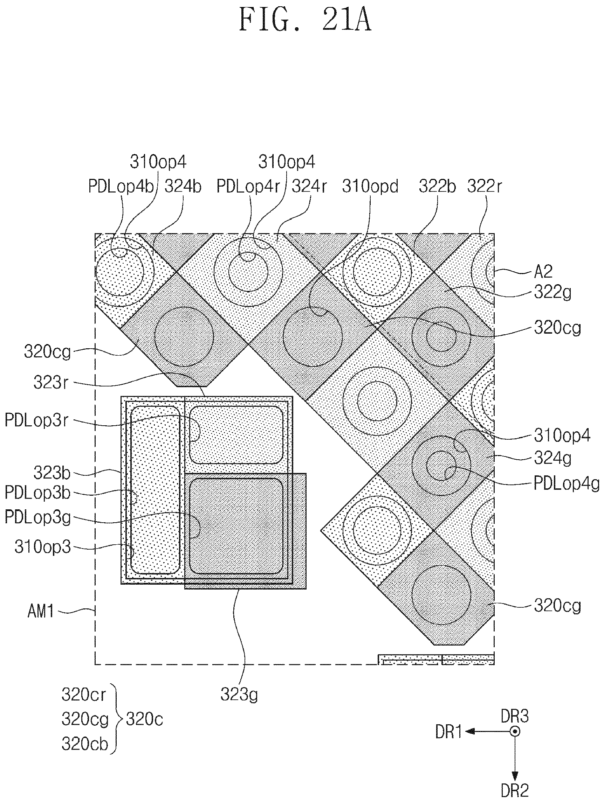

Dummy division openings 310opd may be further defined through the division layer 310. Shapes of the dummy division openings 310opd may be substantially the same as the shape of the second division opening 310op2. The dummy division openings 310opd may overlap dummy colour filters 320c (refer to FIG. 21A), respectively.

In an embodiment of the disclosure, the dummy division openings 310opd may not be defined through the division layer 310. In this case, the dummy colour filters 320c (refer to FIG. 21A) may be disposed on the division layer 310. In an embodiment of the disclosure, dummy pixel definition openings may be further defined through the pixel definition film PDL2 shown in FIG. 6 to overlap the dummy division openings 310opd.

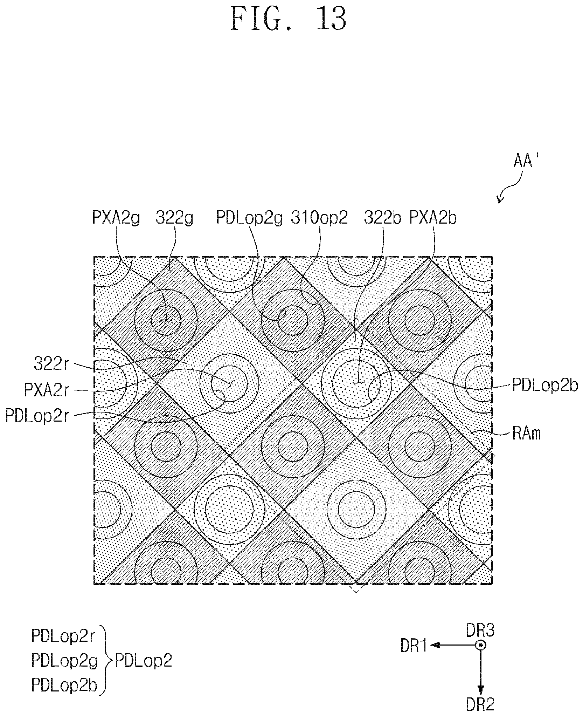

FIG. 13 is an enlarged plan view of an embodiment of a portion of the display panel DP according to the disclosure. The portion shown in FIG. 13 may correspond to a portion AA' of FIG. 12.

Referring to FIGS. 7B and 13, the colour filters 320 may include second colour filters 322r, 322g, and 322b disposed in the second area A2. The second colour filters 322r, 322g, and 322b may include a second-first colour filter 322r, a second-second colour filter 322g, and a second-third colour filter 322b. The second-first, second-second, and second-third colour filters 322r, 322g, and 322b may overlap the second division openings 310op2 of the division layer 310 in a one-to-one correspondence.

Each of the second division openings 310op2 may have a shape different from a shape of each of the second-first, second-second, and second-third colour filters 322r, 322g, and 322b. In addition, the shape of each of the second pixel definition openings PDLop2 of the pixel definition film PDL2 may be different from the shape of each of the second-first, second-second, and second-third colour filters 322r, 322g, and 322b. In an embodiment, in the plan view, each of the second pixel definition openings PDLop2 may have a circular shape, and each of the second division openings 310op2 may have a circular shape. One second division opening 310op2 may have a shape surrounding one second pixel definition opening PDLop2. Each of the second-first, second-second, and second-third colour filters 322r, 322g, and 322b may have a quadrangular shape.

The second pixel definition openings PDLop2 may include a second-first pixel definition opening PDLop2r overlapping the second-first colour filter 322r, a second-second pixel definition opening PDLop2g overlapping the second-second colour filter 322g, and a second-third pixel definition opening PDLop2b overlapping the second-third colour filter 322b.

The second-first colour filter 322r may have a size greater than a size of the second-third colour filter 322b, and the second-first pixel definition opening PDLop2r may have a size smaller than a size of the second-third pixel definition opening PDLop2b.

The second light-emitting areas PXA2r, PXA2g, and PXA2b maybe defined by the second pixel definition openings PDLop2 defined in the second area A2. The second light-emitting areas PXA2r, PXA2g, and PXA2b may include the second-first light-emitting area PXA2r defined by the second-first pixel definition opening PDLop2r, the second-second light-emitting area PXA2g defined by the second-second pixel definition opening PDLop2g, and the second-third light-emitting area PXA2b defined by the second-third pixel definition opening PDLop2b.

Among the second light-emitting areas PXA2r, PXA2g, and PXA2b, the second-second light-emitting area PXA2g may have the smallest size, and the second-third light-emitting area PXA2b may have the largest size. Among the second-first, second-second, and second-third colour filters 322r, 322g, and 322b, the second-first colour filter 322r may have the largest size, and the second-third colour filter 322b may have the smallest size.

One second-first light-emitting area PXA2r, two second-second light-emitting areas PXA2g, and one second-third light-emitting area PXA2b may form one repeating unit RAm. In this case, in the one repeating unit RAm, the size occupied by the two second-second colour filters 322g may be the largest, the size occupied by the one second-first colour filter 322r may be the next largest, and the size occupied by the one second-third colour filter 322b may be the smallest. In an embodiment, a size ratio of the second-first colour filter 322r, the second-second colour filters 322g, and the second-third colour filter 322b may be 29: 54: 17 in the repeating unit RAm.

The size of each of the second-first, second-second, and second-third colour filters 322r, 322g, and 322b may be determined by taking into account the colour of reflected light of the electronic device EDE (refer to FIG. 1A). Accordingly, the size relationship of the light-emitting areas may not be in proportion (coincident) with the size relationship of the colour filters corresponding to the light-emitting areas.

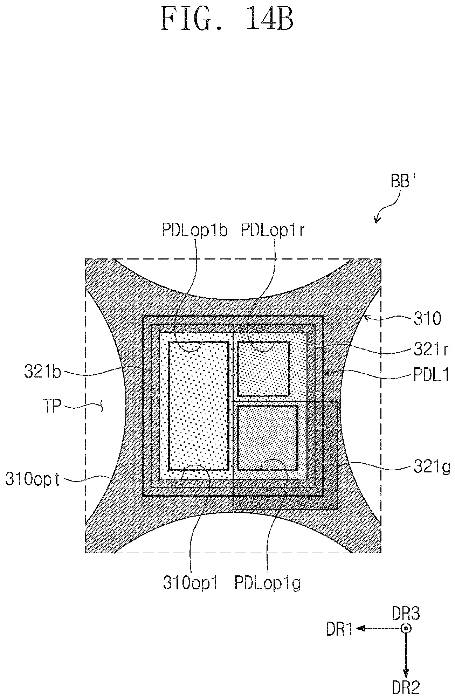

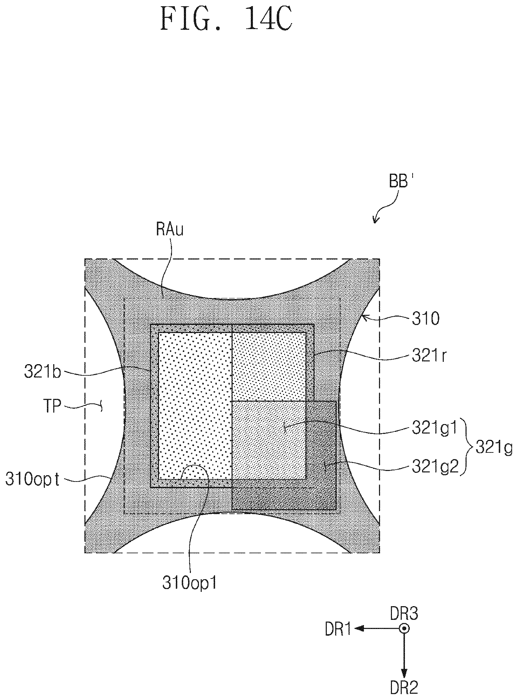

FIGS. 14A, 14B, and 14C are enlarged plan views of an embodiment of a portion of a display panel DP according to the disclosure. The portions respectively shown in FIGS. 14A, 14B, and 14C may correspond to a portion BB' of FIG. 12.

FIGS. 14A, 14B, and 14C illustrate some of the components arranged in the same area to clearly show the arrangement relationship between the components. In an embodiment, FIG. 14A shows a pixel definition pattern PDL1, a division layer 310, and a conductive pattern 240P, FIG. 14B shows the pixel definition pattern PDL1, the division layer 310, and first-first, first-second, and first-third colour filters 321r, 321g, and 321b, and FIG. 14C shows the division layer 310 and the first-first, first-second, and first-third colour filters 321r, 321g, and 321b.

Referring to FIGS. 7A and 14A, first pixel definition openings PDLop1 may be defined through the pixel definition pattern PDL1. The first pixel definition openings PDLop1 may include a first-first pixel definition opening PDLopir, a first-second pixel definition opening PDLopig, and a first-third pixel definition opening PDLop1b.

In FIG. 14A, one first division opening 310op1 defined through the division layer 310 and portions of four transmission openings 310opt arranged around the first division opening 3100p1 are shown. The first-first pixel definition opening PDLopir, the first-second pixel definition opening PDLopig, and the first-third pixel definition opening PDLop1b may overlap the first division opening 3100p1 of the division layer 310.

The conductive pattern 240P may be covered by the division layer 310. Accordingly, the conductive pattern 240P may entirely overlap the division layer 310. The division layer 310 may prevent an external light from being reflected by the conductive pattern 240P.

Referring to FIGS. 7A and 14B, colour filters 320 may include the first colour filters 321r, 321g, and 321b arranged in the first area A1. The first colour filters 321r, 321g, and 321b may include the first-first colour filter 321r, the first-second colour filter 321g, and the first-third colour filter 321b. The first-first colour filter 321r may overlap the first-first pixel definition opening PDLopir, the first-second colour filter 321g may overlap the first-second pixel definition opening PDLopig, and the first-third colour filter 321b may overlap the first-third pixel definition opening PDLop1b. In addition, the first-first, first-second, and first-third colour filters 321r, 321g, and 321b may overlap the first division opening 3100p1 of the division layer 310.

Among the first-first, first-second, and first-third colour filters 321r, 321g, and 321b, the first-second colour filter 321g may have the largest size, and the first-first colour filter 321r may have the smallest size. Accordingly, the first-second colour filter 321g may protrude outward in a direction away from the first-third colour filter 321b than the first-first colour filter 321r.

Referring to FIGS. 7A and 14C, the first-second colour filter 321g may include an overlapping portion 321g1 overlapping a first division opening 310op1 and an extension portion 321g2 extending from the overlapping portion 321g1. The extension portion 321g2 may include a portion of the first-second colour filter 321g, which protrudes outward in the first direction DR1 than the first-first colour filter 321r and another portion of the first-second colour filter 321g, which protrudes outward in the second direction DR2 than the first-third colour filter 321b.

The sizes of the first-first, first-second, and first-third colour filters 321r, 321g, and 321b may be determined such that the colour of reflected light in the first area A1 may be similar to the colour of reflected light in the second area A2 (refer to FIG. 7B). In an embodiment, referring to FIG. 13, the number of the second-second colour filters 322g arranged in the repeating unit RAm of the second area A2 may be greater than the number of the first-second colour filters 321g arranged in a repeating unit RAu of the first area A1. Accordingly, the colour of reflected light in the first area A1 may become similar to the colour of reflected light in the second area A2 by adjusting the size of the first-second colour filter 321g.

In an embodiment of the disclosure, as the sizes of the first-first, first-second, and first-third colour filters 321r, 321g, and 321b are adjusted, the colour of reflected light in the first area A1 and the colour of reflected light in the second area A2 having different shape from that of the first area A1 may become similar to each other. Since the colour of reflected light in the first area A1 and the colour of reflected light in the second area A2 become similar to each other, a difference in reflective luminosity between the first and second areas A1 and A2 may be reduced. Accordingly, when the display panel DP (refer to FIG. 4) is turned off, a probability that the boundary between the first area A1 and the second area A2 is recognized may be reduced.

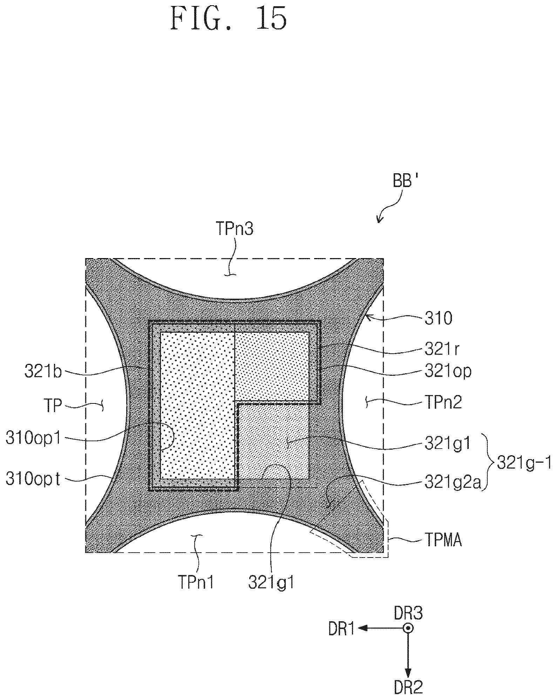

FIG. 15 is an enlarged plan view of an embodiment of a portion of a display panel DP according to the disclosure. The portion shown in FIG. 15 may correspond to the portion BB' of FIG. 12.

Referring to FIG. 15, a division layer 310, and first-first, first-second, and first-third colour filters 321r, 321g-1, and 321b are shown.

The first-second colour filter 321g-1 may include an overlapping portion 321g1 overlapping a first division opening 310op1 and an extension (or extended) portion 321g2a extending from the overlapping portion 321g1. The extension portion 321g2a may extend from the overlapping portion 321g1 to an area TPMA between two transmission areas TPn1 and TPn2 adjacent to each other among transmission areas TP. The area TPMA may overlap the division layer 310. In addition, the area TPMA may overlap the conductive pattern 240P shown in FIG. 14A. Accordingly, the extension portion 321g2a may overlap the division layer 310 and the conductive pattern 240P.

In addition, the extension portion 321g2a may surround the first-first colour filter 321r and the first-third colour filter 321b. Accordingly, a portion of the division layer 310 may have a shape substantially corresponding to a shape of the extension portion 321g2a in the first area A1. In an embodiment, an opening corresponding to a transmission opening 310opt and an opening 321op corresponding to the area in which the first-first colour filter 321r and the first-third colour filter 321b are arranged may be defined through the first-second colour filter 321g-1.

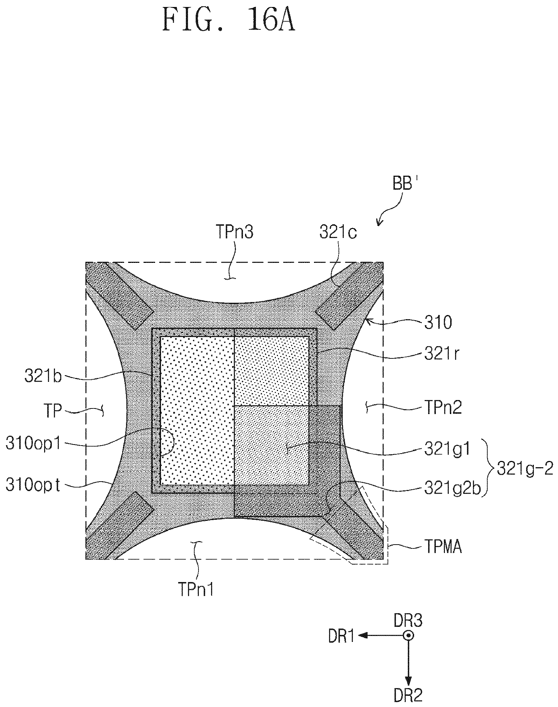

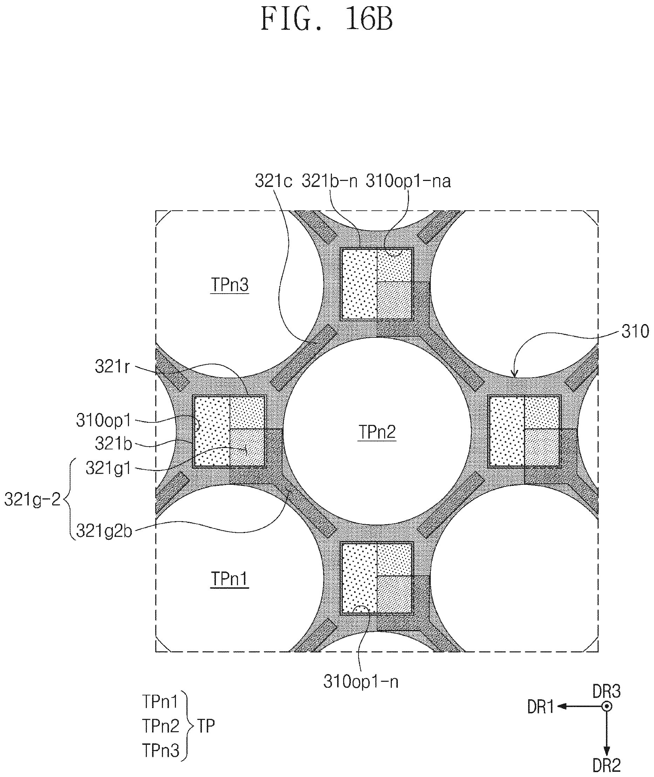

FIGS. 16A and 16B are enlarged plan views of portions of an embodiment of a display panel DP according to the disclosure. The portion shown in FIG. 16A may correspond to the portion BB' of FIG. 12.

Referring to FIGS. 16A and 16B, a division layer 310, first-first, first-second, and first-third colour filters 321r, 321g-2, and 321b, and an additional colour filter 321c are shown.

The first-second colour filter 321g-2 may include an overlapping portion 321g1 overlapping a first division opening 310op1 and an extension portion 321g2b extending from the overlapping portion 321g1. The extension portion 321g2b may extend from the overlapping portion 321g1 to an area TPMA between two transmission areas TPn1 and TPn2 adjacent to each other among transmission areas TP. The area TPMA may overlap the division layer 310. The extension portion 321g2b may extend from the first division opening 3100p1 to another first division opening 310op1-n.

The additional colour filter 321c may be disposed in an area between two transmission areas TPn2 and TPn3 adjacent to each other among the transmission areas TP. The additional colour filter 321c may have the same colour as that of the first-second colour filter 321g-2, however, this is merely one of embodiments. In an embodiment, the additional colour filter 321c may have the same colour as that of the first-first colour filter 321r or the first-third colour filter 321b as long as the difference in colours of reflected lights between the first area A1 and the second area A2 is reduced. In an alternative embodiment, the additional colour filter 321c may be provided in plural, and the additional colour filters 321c may have different colours from each other.

The additional colour filter 321c may face the first-first colour filter 321r overlapping the first division opening 3100p1 and may extend to the first-third colour filter 321b-n overlapping another first division opening 310op1-na.

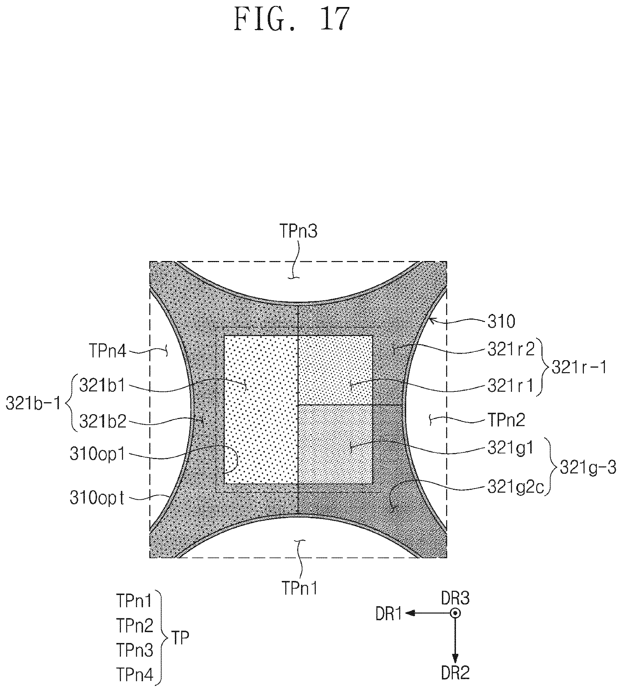

FIG. 17 is an enlarged plan view of a portion of an embodiment of a display panel DP according to the disclosure.

Referring to FIG. 17, a division layer 310 and first-first, first-second, and first-third colour filters 321r-1, 321g-3, and 321b-1 are shown.

The first-first colour filter 321r-1 may include a first overlapping portion 321r1 overlapping a first division opening 3100p1 and a first extension portion 321r2 extending from the first overlapping portion 321r1. The first-second colour filter 321g-3 may include a second overlapping portion 321g1 overlapping the first division opening 310op1 and a second extension portion 321g2c extending from the second overlapping portion 321g1. The first-third colour filter 321b-1 may include a third overlapping portion 321b1 overlapping the first division opening 3100p1 and a third extension portion 321b2 extending from the third overlapping portion 321b1.

The first extension portion 321r2 may extend to an area between two transmission areas TPn2 and TPn3 adjacent to each other, and the second extension portion 321g2c may extend to an area between two transmission areas TPn1 and TPn2 adjacent to each other. The third extension portion 321b2 may extend to an area between two transmission areas TPn3 and TPn4 adjacent to each other and an area between two transmission areas TPn1 and TPn4 adjacent to each other.

In an embodiment of the disclosure, a size ratio between the first-first, first-second, and first-third colour filters 321r-1, 321g-3, and 321b-1 may be adjusted by adjusting a size of each of the first, second, and third extension portions 321r2, 321g2c, and 321b2. In an embodiment, the size of each of the first, second, and third extension portions 321r2, 321g2c, and 321b2 may be adjusted to allow the colour of reflected light in the first area A1 to be similar to the colour of reflected light in the second area A2.

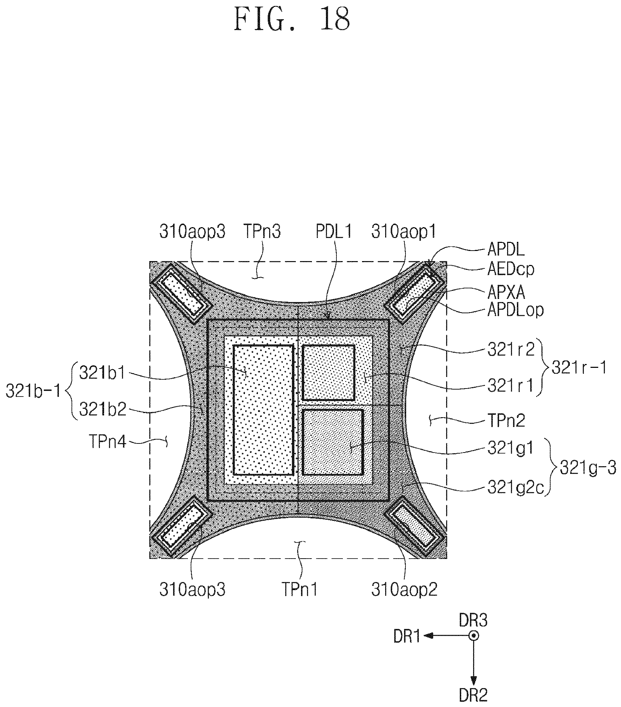

FIG. 18 is an enlarged plan view of an embodiment of a portion of a display panel DP according to the disclosure.

Referring to FIG. 18, additional light-emitting areas APXA may be further provided between transmission areas TP. The additional light-emitting areas APXA may be substantially simultaneously controlled with the first light-emitting areas PXA1r, PXA1g, and PXA1b (refer to FIG. 6) arranged in the element area EP (refer to FIG. 6). That is, the additional light-emitting areas APXA may be defined in copy light-emitting elements AEDcp that are substantially simultaneously controlled by corresponding first pixel circuits PDC1a, PDC1b, and PDCic (refer to FIG. 10A).

In an embodiment, a first additional division opening 310aop1 defined in an area overlapping the first extension portion 321r2, a second additional division opening 310aop2 defined in an area overlapping the second extension portion 321g2c, and third additional division openings 310aop3 defined in areas overlapping the third extension portion 321b2 may be defined in the division layer 310.

In addition, the display panel DP (refer to FIG. 4) may further include additional pixel definition patterns APDL defining the additional light-emitting areas APXA. The first, second, and third additional division openings 310aop1, 310aop2, and 310aop3 may overlap pixel definition openings APDLop defined through the additional pixel definition patterns APDL.

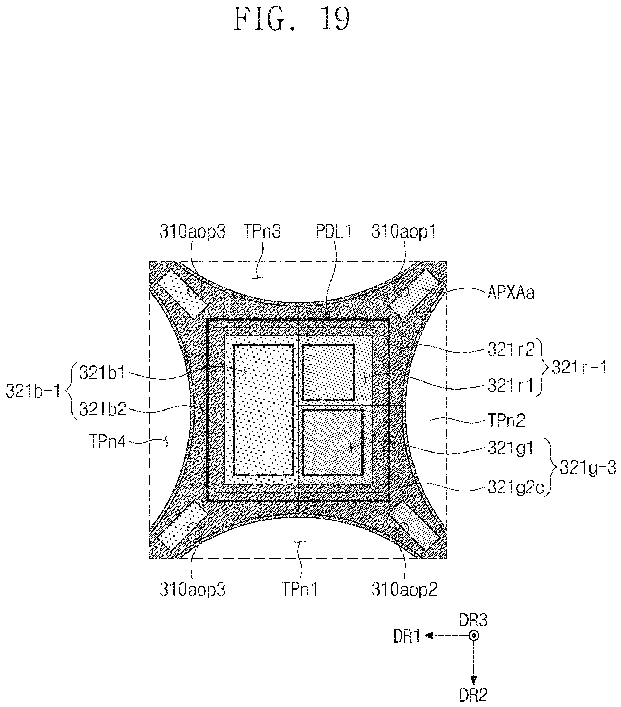

FIG. 19 is an enlarged plan view of an embodiment of a portion of a display panel DP according to the disclosure. In FIG. 19, descriptions will be focused on different features from those of FIG. 18.

Referring to FIG. 19, the additional pixel definition patterns APDL shown in FIG. 18 may be omitted. Accordingly, additional light-emitting areas APXAa shown in FIG. 19 may be defined by first, second, and third additional division openings 310aop1, 310aop2, and 310aop3 defined through a division layer 310.

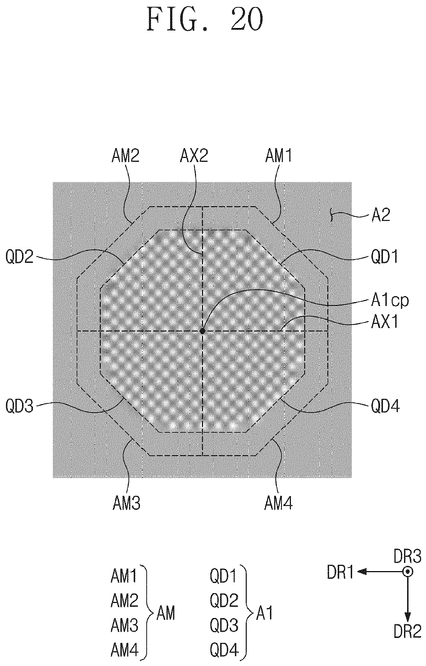

FIG. 20 is a plan view of an embodiment of a portion of a display panel DP according to the disclosure.

Referring to FIG. 20, a first area A1 may be divided into quadrants by a first axis AX1 and a second axis AX2 crossing the first axis AX1 at a center Aicp of the first area A1. FIG. 20 shows first, second, third, and fourth quadrants QD1, QD2, QD3, and QD4.

A boundary area AM may include a first boundary area AM1 adjacent to the first quadrant QD1 of the first area A1, a second boundary area AM2 adjacent to the second quadrant QD2 of the first area A1, a third boundary area AM3 adjacent to the third quadrant QD3 of the first area A1, and a fourth boundary area AM4 adjacent to the fourth quadrant QD4 of the first area A1.

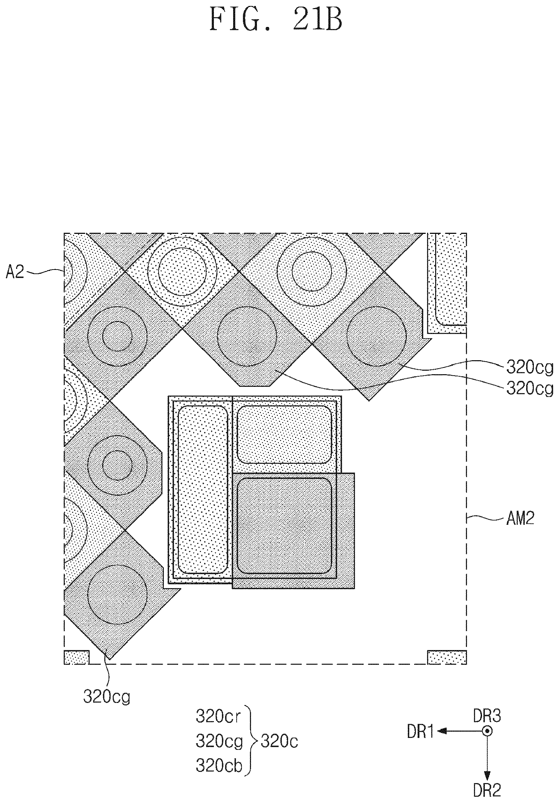

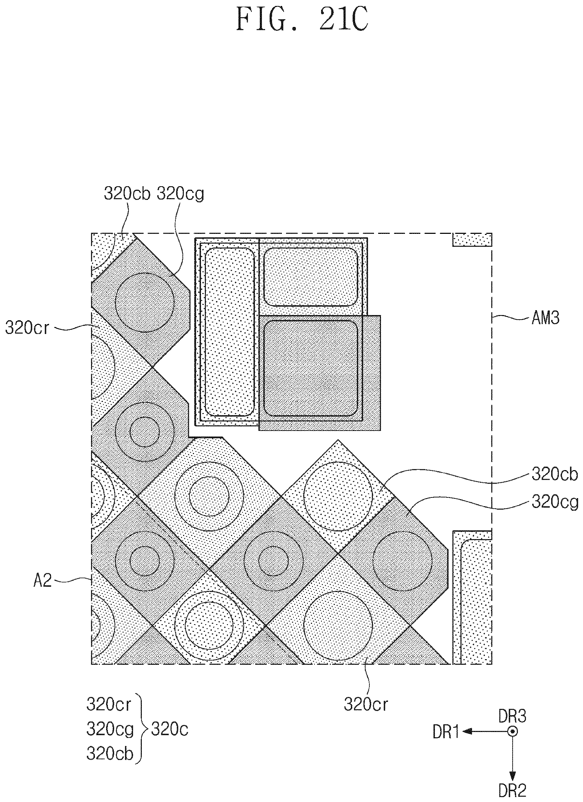

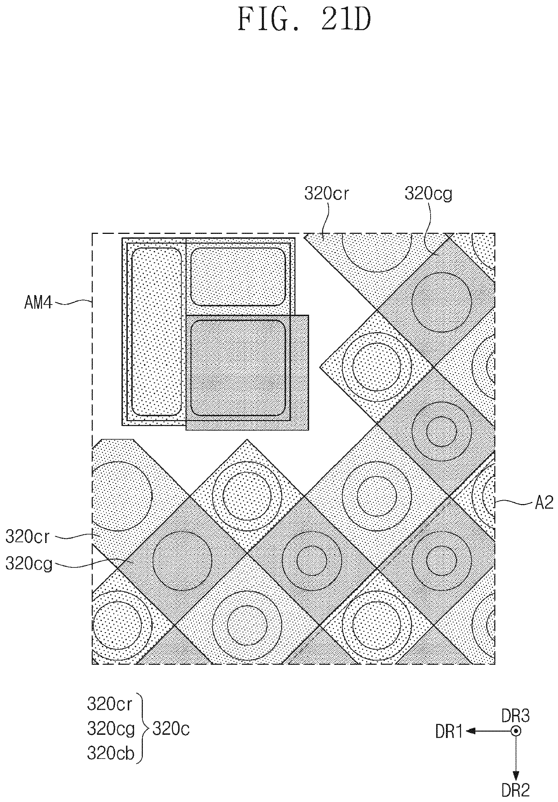

FIGS. 21A, 21B, 21C, and 21D are plan views of an embodiment of portions of the display panel DP according to the disclosure. FIGS. 21A, 21B, 21C, and 21D are plan views showing the first boundary area AM1, the second boundary area AM2, the third boundary area AM3, and the fourth boundary area AM4, respectively.

Referring to FIGS. 20 and 21A to 21D, colour filters 320 may include third colour filters 323r, 323g, and 323b and fourth colour filters 324r, 324g, and 324b, which are arranged in the boundary area AM.

The third colour filters 323r, 323g, and 323b may have substantially the same shape as that of the first colour filters 321r, 321g, and 321b (refer to FIG. 14C), however, they should not be limited thereto or thereby. In an embodiment, the third colour filters 323r, 323g, and 323b may have substantially the same shape as that of the shape of the first colour filters shown in FIGS. 15, 16A, 17, 18, or 19. The fourth colour filters 324r, 324g, and 324b may have substantially the same shape as that of the second colour filters 322r, 322g, and 322b.

The third colour filters 323r, 323g, and 323b may include a third-first colour filter 323r, a third-second colour filter 323g, and a third-third colour filter 323b, which are arranged in each of third division openings 310op3. That is, one third division opening 310op3 may overlap the third-first colour filter 323r, the third-second colour filter 323g, and the third-third colour filter 323b. In an embodiment, third pixel definition openings PDLop3r, PDLop3g and PDLop3b may overlap the third-first colour filter 323r, the third-second colour filter 323g, and the third-third colour filter 323b, respectively. The fourth colour filters 324r, 324g, and 324b may include a fourth-first colour filter 324r, a fourth-second colour filter 324g, and a fourth-third colour filter 324b. The fourth-first, fourth-second, fourth-third colour filters 324r, 324g, and 324b may overlap fourth division openings 310op4 of a division layer 310 in a one-to-one correspondence. In an embodiment, fourth pixel definition openings PDLop4r, PDLop4g and PDLop4b may overlap the fourth-first colour filter 324r, the fourth-second colour filter 324g, and a fourth-third colour filter 324b, respectively.

The display panel DP (refer to FIG. 4) may further include dummy colour filters 320c arranged in the boundary area AM and disposed between the third color filters 323r, 323g, and 323b and the fourth color filters 324r, 324g, and 324b. The dummy colour filters 320c may overlap the dummy pixels DPX described with reference to FIG. 11A. The dummy pixels DPX may not include a pixel electrode. Accordingly, the dummy colour filters 320c may not overlap pixel electrodes.

The dummy colour filters 320c may overlap dummy division openings 310opd. In addition, a pixel definition opening may not be defined through the pixel definition film PDL2 (refer to FIG. 6) overlapping the dummy colour filters 320c. In an embodiment, the dummy pixel definition openings may be further defined through the pixel definition film PDL2 (refer to FIG. 6) overlapping the dummy colour filters 320c.

The dummy colour filters 320c may include a plurality of first dummy colour filters 320cr, a plurality of second dummy colour filters 320cg, and a plurality of third dummy colour filters 320cb. The first dummy colour filters 320cr, the second dummy colour filters 320cg, and the third dummy colour filters 320cb may have colours different from each other. In an embodiment, the first dummy colour filters 320cr may be red colour filters, the second dummy colour filters 320cg may be green colour filters, and the third dummy colour filters 320cb may be blue colour filters.

The dummy colour filters 320c maybe arranged according to arrangement rules corresponding to the first, second, third, and fourth boundary areas AM1, AM2, AM3, and AM4, respectively. In an embodiment, the dummy colour filters 320c that are arranged in the same manner as that of the second colour filters 322r, 322g, and 322b may be arranged in the first, second, third, and fourth boundary areas AM1, AM2, AM3, and AM4. Accordingly, the colour of reflected light in the boundary area AM may be substantially similar to the colour of reflected light in the second area A2.

In an embodiment, the second dummy colour filters 320cg may be arranged in the first boundary area AM1 and the second boundary area AM2, the first dummy colour filters 320cr, the second dummy colour filters 320cg, and the third dummy colour filters 320 may be arranged in the third boundary area AM3, and the first dummy colour filters 320cr and the second dummy colour filters 320cg may be arranged in the fourth boundary area AM4.

Although the embodiments of the disclosure have been described, it is understood that the disclosure should not be limited to these embodiments but various changes and modifications may be made by one ordinary skilled in the art within the scope of the invention as hereinafter claimed. Therefore, the disclosed subject matter should not be limited to any single embodiment described herein, and the scope of the inventive concept shall be determined according to the attached claims.

## Claims

1. An electronic device comprising:
a display panel comprising a first area comprising a plurality of transmission areas and an element area, a second area spaced apart from the first area, and a boundary area defined between the first area and the second area, the display panel comprising:
a division layer in which a plurality of first division openings is defined in the first area and a plurality of second division openings is defined in the second area;
a plurality of first colour filters comprising a first-first colour filter, a first-second colour filter, and a first-third colour filter, which are arranged in each of the plurality of first division openings; and
a plurality of second colour filters arranged in one-to-one correspondence with the plurality of second division openings.

2. The electronic device of claim 1, wherein a plurality of transmission openings is defined in the division layer in the first area, and each of the plurality of first division openings is defined between four of the plurality of transmission openings, wherein the first-second colour filter comprises an overlapping portion overlapping one first division opening among the plurality of first division openings and an extension portion extending from the overlapping portion.

3. The electronic device of claim 2, wherein the extension portion comprises a portion of the first-second colour filter, which protrudes further in a first direction than the first-first colour filter, and a portion of the first-second colour filter, which protrudes further in a second direction crossing the first direction than the first-third colour filter.

4. The electronic device of claim 2 or 3, wherein the extension portion extends from the overlapping portion to an area between two transmission areas adjacent to each other among the plurality of transmission areas, and/or wherein the extension portion surrounds the first-first colour filter and the first-third colour filter.

5. The electronic device of any one of claims 2 to 4, wherein the shape of a portion of the division layer corresponds to the shape of the extension portion in the first area.

6. The electronic device of any one of claims 2 to 5, wherein the display panel further comprises an additional colour filter having the same colour as the first-second colour filter, and the additional colour filter is disposed in an area between two transmission areas adjacent to each other among the plurality of transmission areas.

7. The electronic device of claim 6, wherein the extension portion extends to the first-third colour filter overlapping another first division opening among the plurality of first division openings, and the additional colour filter faces the first-first colour filter overlapping the one first division opening and extends to the first-third colour filter overlapping still another first division opening among the plurality of first division openings.

8. The electronic device of claim 1, wherein a plurality of transmission openings is defined in the division layer in the first area, and each of the plurality of first division openings is defined between four of the plurality of transmission openings, wherein the first-first colour filter comprises a first overlapping portion overlapping one first division opening among the plurality of first division openings and a first extension portion extending from the first overlapping portion, the first-second colour filter comprises a second overlapping portion overlapping the one first division opening and a second extension portion extending from the second overlapping portion, and the first-third colour filter comprises a third overlapping portion overlapping the one first division opening and a third extension portion extending from the third overlapping portion.

9. The electronic device of claim 8, wherein the first extension portion extends to an area between two transmission areas adjacent to each other among the plurality of transmission areas, the second extension portion extends to an area between two transmission areas adjacent to each other among the plurality of transmission areas, and the third extension portion extends to an area between two transmission areas adjacent to each other among the plurality of transmission areas.

10. The electronic device of claim 9, wherein a first additional division opening defined in an area overlapping the first extension portion, a second additional division opening defined in an area overlapping the second extension portion, and a third additional division opening defined in an area overlapping the third extension portion are defined in the division layer.

11. The electronic device of any one of the preceding claims, wherein a plurality of third division openings and a plurality of fourth division openings, which are defined in the boundary area, are defined in the division layer,
each of the plurality of third division openings has the same shape as that of each of the plurality of first division openings, and
each of the plurality of fourth division openings has the same as that of each of the plurality of second division openings.

12. The electronic device of claim 11, wherein the display panel further comprises:
a plurality of third colour filters comprising a third-first colour filter, a third-second colour filter, and a third-third colour filter, which are arranged in each of the plurality of third division openings; and
a plurality of fourth colour filters arranged in one-to-one correspondence with the plurality of fourth division openings.

13. The electronic device of claim 12, wherein the display panel further comprises a plurality of dummy colour filters arranged in the boundary area, the plurality of dummy colour filters comprises a plurality of first dummy colour filters, a plurality of second dummy colour filters, and a plurality of third dummy colour filters, and the plurality of first dummy colour filters, the plurality of second dummy colour filters, and the plurality of third dummy colour filters have different colours, optionally wherein a plurality of dummy division openings defined in the boundary area and overlapping the plurality of dummy colour filters is defined in the division layer.

14. The electronic device of claim 13, wherein the first area is divided into quadrants by a first axis and a second axis crossing the first axis at a center of the first area, the boundary area comprises a first boundary area adjacent to a first quadrant of the first area, a second boundary area adjacent to a second quadrant of the first area, a third boundary area adjacent to a third quadrant of the first area, and a fourth boundary area adjacent to a fourth quadrant of the first area, and the plurality of dummy colour filters is arranged according to arrangement rules corresponding to the first, second, third, and fourth boundary areas, respectively, optionally wherein the plurality of second dummy colour filters is arranged in the first boundary area and the second boundary area, the plurality of first dummy colour filters, the plurality of second dummy colour filters, and the plurality of third dummy colour filters are arranged in the third boundary area, and the plurality of first dummy colour filters and the plurality of second dummy colour filters are arranged in the fourth boundary area.

15. The electronic device of claim 1, wherein the display panel further comprises a pixel definition layer through which a plurality of pixel definition openings defining a plurality of light-emitting areas is defined, the plurality of second colour filters comprises a second-first colour filter, a second-second colour filter, and a second-third colour filter, the plurality of pixel definition openings comprises a first pixel definition opening overlapping the second-first colour filter, a second pixel definition opening overlapping the second-second colour filter, and a third pixel definition opening overlapping the second-third colour filter, the second-first colour filter has a size greater than a size of the second-third colour filter, and the first pixel definition opening has a size smaller than a size of the third pixel definition opening, optionally wherein the display panel further comprises:
a first spacer disposed on the pixel definition layer and disposed in the second area and the boundary area;
a plurality of first protruded spacers disposed on the first spacer and disposed in the second area;
a second spacer disposed on the pixel definition layer and disposed in the first area; and
a second protruded spacer disposed on the second spacer, wherein the plurality of first protruded spacers does not overlap the boundary area.
